Europäisches Patentamt

European Patent Office

Office européen des brevets

(19)

(11)  EP 1 585 149 A1

(12)  EUROPEAN PATENT APPLICATION
published in accordance with Art. 158(3) EPC

(43) Date of publication:
12.10.2005  Bulletin 2005/41

(51) Int Cl.⁷: **H01F 10/16**, H01F 10/13,
H01F 17/04, H01F 17/00

(21) Application number: 03780982.9

(22) Date of filing: 22.12.2003

(86) International application number:
**PCT/JP2003/016458**

(87) International publication number:
**WO 2004/059668 (15.07.2004 Gazette 2004/29)**

(84) Designated Contracting States:
**AT BE BG CH CY CZ DE DK EE ES FI FR GB GR
HU IE IT LI LU MC NL PT RO SE SI SK TR**

(30) Priority: **26.12.2002 JP 2002377797**

(71) Applicant: **TDK Corporation
Tokyo 103-8272 (JP)**

(72) Inventors:
• **CHOI, Kyung-Ku, TDK Corporation
Tokyo 103-8272 (JP)**
• **MURASE, Taku, TDK Corporation
Tokyo 103-8272 (JP)**

(74) Representative: **HOFFMANN EITLE
Patent- und Rechtsanwälte
Arabellastrasse 4
81925 München (DE)**

(54)  **MAGNETIC THIN FILM OR COMPOSITE MAGNETIC THIN FILM FOR HIGH FREQUENCY AND MAGNETIC DEVICE INCLUDING THE SAME**

(57)  There can be obtained a magnetic thin film for high frequency 1 which has both a high permeability and a high saturation magnetization by combining a T-L composition layer 5 comprising a T-L composition, wherein T is Fe or FeCo, and L is at least one element selected from the group consisting of C, B and N, with a Co based amorphous alloy layer 3 disposed on either of the surfaces of the T-L composition layer 5. Further, there can be obtained a magnetic thin film for high frequency 1 which has both a high permeability and a high saturation magnetization, and at the same time has a high resistivity by further providing the magnetic thin film with, in addition to the T-L composition layer 5 and the Co based amorphous alloy layer 3, a high resistance layer 7 having an electric resistance higher than the T-L composition layer 5 and the Co based amorphous alloy layer 3.

FIG. 1

EP 1 585 149 A1

**Description**

Technical Field

The present invention relates to a magnetic thin film suitably used in a gigahertz (GHz) high frequency range and a magnetic device including the same.

Background Art

Along with miniaturization and sophistication of magnetic devices, demand has grown for magnetic thin film materials having high saturation magnetization and high permeability in a high frequency range, in particular, the gigahertz range (hereinafter, referred to as "GHz range") .

For example, the monolithic microwave integrated circuit (MMIC), for which demand is growing mainly for use in wireless transmitters/receivers and portable information terminals, is a high frequency integrated circuit having a configuration in which active elements such as transistors and passive elements such as transmission line, resistors, capacitors and inductors are integrated on a semiconductor substrate made of Si, GaAs, InP and the like.

In such an MMIC, the passive elements, in particular, the inductors and capacitors occupy larger areas than the active elements. The larger areas occupied by the passive elements as a result lead to mass consumption of expensive semiconductor substrates, namely, the cost rise of the MMICs. Accordingly, now it is a challenge to reduce the areas occupied by the passive elements for the purpose of reducing the chip area and thereby lowering the manufacturing cost of the MMICs.

As the inductors used in MMICs, planar spiral coils are frequently used. In this connection, there has already been proposed a method (in other words, a method for obtaining an inductance comparable with a conventional inductance even by using a small occupied area) for increasing the inductance of such a spiral coil by inserting a soft magnetic thin film on the top and back sides or on one side of the spiral coil (for example, J. Appl. Phys., 85, 7919 (1999)).

However, for the purpose of applying a magnetic material to the inductor in an MMIC, a thin film magnetic material which is high in permeability and low in loss in the GHz range is demanded before everything. Additionally, high resistivity is also demanded for the thin film magnetic material for the purpose of reducing the eddy current loss.

So far, alloys comprising Fe or FeCo as a main component have been well known as magnetic materials having high saturation magnetization. However, when a magnetic thin film made of a Fe based alloy or a FeCo based alloy is fabricated by means of a deposition technique such as the sputtering technique, the saturation magnetization of the film obtained is high, but the coercive force thereof is high and the resistivity thereof is low, so that satisfactory high frequency properties thereof can be hardly obtained.

On the other hand, Co based amorphous alloys are known as materials excellent in soft magnetic properties. Such a Co based amorphous alloy mainly comprises an amorphous substance comprising Co as a main component and at least one element selected from the group consisting of Y, Ti, Zr, Hf, Nb, Ta and the like. However, when a magnetic thin film made of a Co based amorphous alloy having zero magnetostriction composition is formed by means of a deposition technique such as the sputtering technique, the permeability of the film obtained is high, but the saturation magnetization thereof is of the order of 11 kG (1.1 T) to be lower than those of Fe based alloys. Additionally, for the frequencies of about 100 MHz and higher, the loss component (the imaginary part of the permeability, $\mu''$) becomes large and the quality factor Q value comes to be 1 or less, so that the film concerned cannot be judged suitable as a magnetic material to be used in the GHz range.

For the purpose of actualizing the inductor for use in the GHz range by use of such hardly applicable materials, an attempt has been made to shift the resonance frequency to the higher frequencies by micro-patterning a magnetic thin film so as to be increased in shape magnetic anisotropy energy (for example, J. Magnetics Soc. Japan, 24, 879 (2000)). However, this method involves a problem such that the production process tends to be complicated and additionally the effective permeability of the magnetic thin film is lowered.

Under such current circumstances as described above, investigations have hitherto been made on high saturation magnetization thin films based on multilayer film in which a soft magnetic layer and a high saturation magnetization layer are alternately laminated. More specifically, there have been reported various combinations such as CoZr/Fe (J. Magnetics Soc. Japan, 16, 285 (1992)), FeBN/FeN (Japanese Patent Laid-Open No. 5-101930), FeCrB/Fe (J. Appl. Phys., 67, 5131 (1990)), and Fe-Hf-C/Fe (J. Magnetics Soc. Japan, 15, 403 (1991)). Any of these combinations has an effect to enhance the saturation magnetization. However, any of these combinations cannot yield high permeability in the high frequency range, making application to the GHz range be hardly expected. Additionally, the resistivities of these combinations take such insufficient magnitudes of 100 $\mu\Omega\cdot$cm or less and the high frequency loss due to skin effect comes to be large to make these combinations hardly applicable to inductors for use in high frequencies.

Under such current circumstances as described above, the present invention has been thought up and takes as its object the provision of a magnetic thin film for high frequency having high permeability in the GHz range, high saturation magnetization and high resistivity. Additionally, the present invention takes as its another object the provision of a magnetic device including such a magnetic thin film.

Disclosure of the Invention

The inventors have made various investigations for the purpose of obtaining a magnetic thin film for high frequency which has a high permeability in the GHz range and a high saturation magnetization, and at the same time a high resistivity. Consequently, the inventors have found that there can be obtained a magnetic thin film for high frequency which has both a high permeability and a high saturation magnetization by combining a first layer comprising a T-L composition (wherein T is Fe or FeCo, and L is at least one element selected from the group consisting of C, B and N), and a second layer comprising a Co based amorphous alloy and disposed on either of the surfaces of the first layers. The present inventors have also found that there can be obtained a magnetic thin film for high frequency which has both a high permeability and a high saturation magnetization, and at the same time has a high resistivity by further providing the magnetic thin film with, in addition to the first layer and the second layer, a third layer having an electric resistance higher than the first layer and the second layer. More specifically, the present invention provides a magnetic thin film for high frequency, characterized in that the magnetic thin film comprises a first layer comprising a T-L composition (wherein T is Fe or FeCo, and L is at least one element selected from the group consisting of C, B and N), a second layer comprising a Co based amorphous alloy and disposed on either of the surfaces of the first layer, and a third layer disposed on either of the first layer side or the second layer side and having an electric resistance higher than the first layer and the second layer; wherein a plurality of the first layers, a plurality of the second layers and a plurality of the third layers are laminated to form a multilayer film structure. The reason for the fact that it is preferable to use the T-L composition (wherein T is Fe or FeCo, and L is at least one element selected from the group consisting of C, B and N), and the Co based amorphous alloy will be described in detail in embodiments to be described later.

In the magnetic thin film for high frequency of the present invention provided with such a configuration as described above, the third layers mainly contribute to suppression of the high frequency loss due to skin effect. For the purpose of effectively suppressing the high frequency loss due to skin effect, it is preferable to dispose one of the third layers every time when laminating of the first layer and the second layer is repeated a predetermined number of times. The predetermined number of times may be set, for example, at 1 to 5. For example, when the predetermined number of times is set at 2, one of the third layers is laminated when the two-first layers and the two-second layers have been laminated.

T constituting the T-L composition is preferably FeCo.

When FeCo is selected as T, the concentration of Co is preferably 10 to 50 at%.

L constituting the T-L composition is preferably C and/or B.

The Co based amorphous alloy is preferably an alloy which contains Co as a main component and also an element M, wherein M is at least one element selected from the group consisting of B, C, Si, Ti, V, Cr, Mn, Fe, Ni, Y, Zr, Nb, Mo, Hf, Ta and W. In this case, the concentration of the element M in the Co based amorphous alloy is preferably 10 to 30 at%.

In the magnetic thin film for high frequency of the present invention, the third layers each may be formed of at least one of a granular structure film, an oxide film, a nitride film and a fluoride film. According to the magnetic thin film for high frequency of the present invention, there can be obtained excellent properties such that the saturation magnetization thereof is 14 kG (1.4 T) or more and the resistivity thereof is 200 $\mu\Omega$ cm or more under the condition that the first layers, the second layers and the third layers are laminated. Moreover, it is also possible that the real part ($\mu'$) of the complex permeability at 1 GHz is made to be 300 or more, and additionally the quality factor Q (Q = $\mu'/\mu''$) is made to be 10 or more. It is to be noted that in the present invention, these properties can be obtained from the as-deposited film. In other words, the judgment as to whether the magnetic thin film concerned has properties defined in the present invention can be made on the basis of the value measured under the condition that a treatment such as a heat treatment is not applied after the completion of the deposition, the time elapsed from the completion of the deposition having nothing to do with this judgment. However, even when a treatment such as a heat treatment is applied after the completion of the deposition, the film concerned having the properties defined in the present invention, needless to say, falls within the scope of the present invention. The same situations will be seen in what follows.

As described above, a high permeability and a high saturation magnetization are attained by adopting a T-L composition (wherein T is Fe or FeCo, and L is at least one element selected from the group consisting of C, B and N), for the first layers and a Co based amorphous alloy for the second layers. According to the investigations of the present inventors, it is extremely effective to control the film thickness of each of the first layers and the film thickness of each of the second layers for the purpose of obtaining a desired permeability and a desired saturation magnetization. Accordingly, in the present invention, when T1 denotes the thickness of each of the first layers and T2 denotes the thickness of each of the second layers, it is recommended that T1 falls within the range of 0.5 to 3.0 nm and T1/T2 is set to fall within the range of 0.8 to 3.0. Additionally, when T1 falls within the range of 3 to 70 nm, it is effective that T1/T2 is set to fall within the range of 0.15 to 3.50.

Moreover, the present invention provides a composite magnetic thin film, comprising first layers each of which is mainly composed of Fe or FeCo, has by itself a saturation magnetization of 16 kG (1.6 T) or more, is constituted as a columnar structure with an aspect ratio of 1.4 or less or an amorphous structure; and second layers each of which is mainly composed of Co, and has the properties by itself such that a permeability of 1000 or more (measurement frequency: 10 MHz), a saturation magnetization of 10 kG (1.0 T) or more, and a resistivity is 100 $\mu\Omega$ cm or more; the composite magnetic thin film being a laminate in which the first layers and the second layers are laminated, characterized in that third layers each having an electric resistance higher than the second layers are disposed on the surface and/or in the interior of the laminate. By using a magnetic material substance for the third layers, there can be obtained a composite magnetic thin film having both high magnetic properties and a high electric resistance. As such a magnetic material substance, for example, a substance having a granular structure is preferable. It is desirable that the total thickness of the composite magnetic thin film is set at 200 to 3000 nm.

Although the presence of the third layers makes it possible to obtain a high electric resistance, when the proportion of the third layers in relation to the composite magnetic thin film exceeds 40 vol%, the proportion of the first layers and the proportion of the second layers tend to be small, and the saturation magnetization and the real part of the permeability tend to be decreased. Accordingly, in the present invention, the proportion of the third layers in relation to the composite magnetic thin film is set at 40 vol% or less, and preferably at 3 to 20 vol%.

Additionally, by making the first layer have an amorphous structure, higher soft magnetic properties can be obtained.

Yet additionally, the present invention provides a magnetic device such as an inductor or a transformer suitably used in the GHz range. More specifically, the present invention provides a magnetic device including a magnetic thin film for high frequency, characterized in that the magnetic thin film for high frequency comprises first layers each comprising a T-L composition, wherein T is Fe or FeCo, and L is at least one element selected from the group consisting of C, B and N, second layers each comprising a Co based amorphous alloy and each disposed on either of the surfaces of any one of the first layers, and third layers each disposed on either side of any one of the first layers or any one of the second layers and each having an electric resistance higher than the first layers and the second layers, wherein a plurality of the first layers, a plurality of the second layers and a plurality of the third layers are laminated to form a multilayer film structure.

In this connection, the third layers are each preferably formed of a granular structure film.

Additionally, the concentration of the element L contained in the T-L composition is preferably 2 to 20 at%.

Examples of the magnetic device of the present invention include an inductor, a transformer and the like, more specifically, a magnetic device in which the magnetic thin films for high frequency are disposed to face each other to sandwich a coil and an inductor for use in a monolithic microwave integrated circuit.

Brief Description of the Drawings

Figure 1 is a cross-sectional view of a magnetic thin film for high frequency of a present embodiment;

Figure 2 is a chart showing the X-ray diffraction results of composite magnetic thin films in each of which Fe-C thin films of 3 nm or less in the thickness T1 and CoZrNb amorphous alloy thin films are laminated;

Figure 3 is a schematic cross-sectional view showing the condition of the grains in the Fe based thin film or the FeCo based thin film;

Figure 4 is a schematic cross-sectional view showing the condition of the grains in the Fe-C thin films when the Fe-C thin films and the Co based amorphous alloy thin films are laminated;

Figure 5 is a partial enlarged view of Figure 4;

Figure 6 is a cross-sectional view of a magnetic thin film for high frequency of the present embodiment in which the laminating period is different from that in Figure 1;

Figure 7 is a plan view showing an example of an inductor to which a magnetic thin film for high frequency of the present embodiment is applied;

Figure 8 is a cross-sectional view along the A-A line in Figure 7;

Figure 9 is a cross-sectional view showing an example of another inductor to which a magnetic thin film for high frequency of the present invention is applied;

Figure 10 is a plan view showing an example of another inductor to which a magnetic thin film for high frequency of the present embodiment is applied;

Figure 11 is a cross-sectional view along the A-A line in Figure 10;

Figure 12 is a table showing the configurations of the composite magnetic thin films obtained in Examples 1 to 8 and in Comparative Example 1;

Figure 13 is a table showing the magnetic properties, the high frequency permeability properties, and the resistivities of the composite magnetic thin films obtained in Examples 1 to 8 and in Comparative Example 1;

Figure 14 is a schematic cross-sectional view of a composite magnetic thin film fabricated in Example 4;

Figure 15 is a table showing the configurations, the magnetic properties, the high frequency permeability properties, and the resistivities of the composite magnetic thin films obtained in Examples 9 to 15; and

Figure 16 is a table showing the configurations, the magnetic properties, the high frequency permeability properties, and the resistivities of the composite magnetic thin films obtained in Examples 16 to 26.

Best Mode for Carrying Out the Invention

Description will be made below on a magnetic thin film for high frequency of a present embodiment.

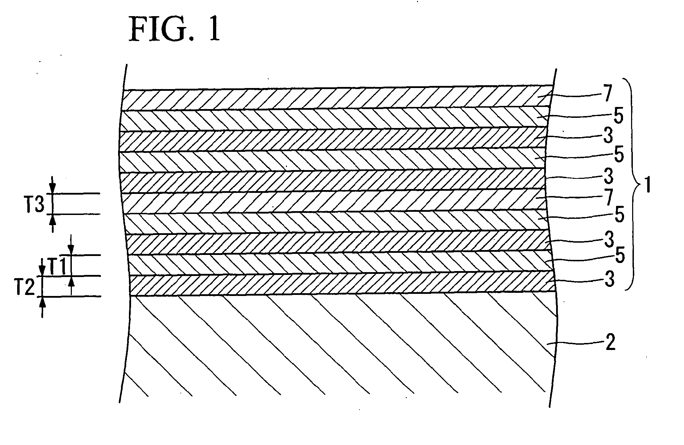

A magnetic thin film for high frequency (a composite magnetic thin film) 1 of the present embodiment is, as shown in a schematic cross-sectional view of Figure 1, a composite magnetic thin film comprising a multilayer film configuration in which a plurality of Co based amorphous alloy layers (second layers) 3, a plurality of T-L composition layers (first layers) 5 and a plurality of high resistance layers (third layers) 7 are laminated. In an embodiment shown in Figure 1, there is shown an example of a multilayer film configuration comprising ten layers in total including the four Co based amorphous alloy layers 3, the four T-L composition layers 5 and the two high resistance layers 7. As shown in Figure 1, the T-L composition layers 5 are each disposed on one surface of any one of the Co based amorphous alloy layers 3. The high resistance layers 7 are each disposed on either of the Co based amorphous alloy layer 3 side or the T-L composition layer 5 side.

First, description will be made on the T-L composition layers 5.

T in the T-L composition layers 5 is Fe or FeCo, and L in the same layers is at least one element selected from the group consisting of C, B and N. A thin film made of an alloy mainly composed of Fe or FeCo exhibits high saturation magnetization, but tends to be high in coercive force and low in resistivity. Accordingly, the present invention comprises L (at least one element selected from the group consisting of C, B and N) capable of improving the soft magnetic properties . The T-L composition layers 5 include two different modes. One of the modes, the first mode, is the one having a columnar structure in which the aspect ratio of each of the T-L composition layers 5 is 1.4 or less; the actualization of this mode permits yielding a high saturation magnetization and excellent soft magnetic properties. The other of the modes, the second mode, is an amorphous structure; the actualization of the amorphous structure of the T-L composition layers 5 permits attaining a further improvement of the soft magnetic properties and a high electric resistance. For the purpose of achieving some advantageous effects in the high frequency properties, it is preferable that the T-L composition layers 5 each have, by itself, a property such that the saturation magnetization thereof is 16 kG (1.6 T) or more.

Even in the mode having a columnar structure in which the aspect ratio of each of the T-L composition layers 5 is 1.4 or less, the amorphous structure is formed at the early stage of the thin film formation, as will be described later, and accordingly the columnar structure in the present invention should be interpreted as including this amorphous structure portion.

When the film thickness of each of the T-L composition layers 5 becomes large and the aspect ratio thereof exceeds 1.4 to be 2.0 or more, the vertical magnetic anisotropy is manifested strongly and the soft magnetic properties are deteriorated. In the present invention, it is most preferable that the aspect ratios of all the grains present in the T-L composition layers 5 are 1.4 or less; however, the present invention admits the partial inclusion of the crystal grains having aspect ratio increments of 30% or less, and moreover, 10% or less. Accordingly, in the present invention, the thickness (T1) of each of the T-L composition layers 5 is made to be 100 nm or less, preferably 70 nm or less. When T1 is 3 nm or less, the T-L composition layers 5 come to take amorphous structure as will be described later, and no performance degradation takes place even when T1 is decreased down to, for example, 0.2 nm. However, if T1 is too small, the number of the laminating operations is increased, leading to a problem in fabrication such that the deposition time is elongated. Consequently, T1 is preferably 0.5 nm or more, and more preferably 1.0 nm or more.

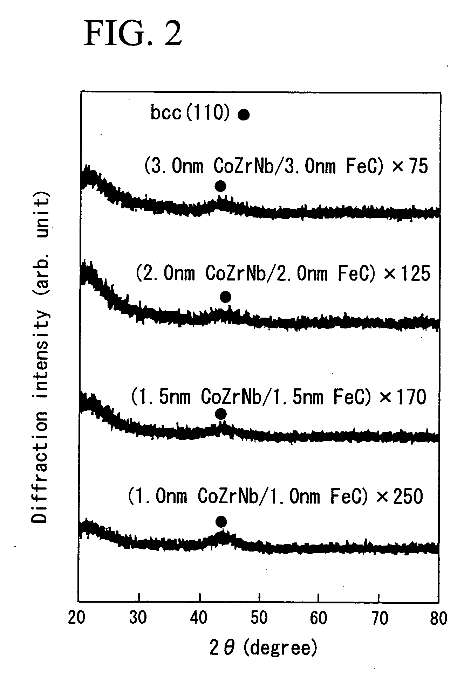

Figure 2 shows the X-ray diffraction results of a composite magnetic thin film in which Fe-C thin films of 3 nm or less in the thickness T1 and CoZrNb amorphous alloy thin films are laminated. As can be seen from Figure 2, the laminates, in which the thickness of each of the Fe-C thin films is 3 nm orless, each exhibit a dif fraction peak of the bcc (110) crystal plane of the Fe-C system having a typical broad shape for an amorphous system.

In the T-L composition layers 5 of the present invention, the concentration of the element L (at least one element selected from the group consisting C, B and N) contained therein is set at 2 to 20 at%, and preferably 4 to 10 at%. When the concentration of the element L is less than 2 at%, the columnar crystal of the bcc structure tends to grow perpendicularly to the substrate, the coercive force becomes high, and the resistivity comes to be low, making it difficult to obtain satisfactory high frequency properties. On the other hand, when the concentration of the element L exceeds 20 at%, the anisotropic magnetic filed is decreased and hence the resonance frequency is lowered, so that sufficient functioning as a thin film for use in high frequency applications becomes difficult. Additionally, the adoption of FeCo as T is preferable. The adoption of FeCo as T makes it possible to obtain a higher saturation magnetization than that in the case where Fe is adopted alone. In this case, the content of Co may be determined within the range of 80 at% or less, and Co is contained preferably within the range of 10 to 50 at%, and more preferably within the range of 20 to 50 at%. The present invention admits the inclusion of elements other than Fe and FeCo within ranges giving no adverse effects on the present invention.

Next, description will be made below on the Co based amorphous alloy layers 3.

The Co based amorphous alloy is characterized by having a high permeability and a high resistance (the resistivity ranges from 100 to 150 $\mu\Omega$ cm) and hence is effective in suppressing the eddy current loss in the high frequency range. For this reason, the present invention adopts the Co based amorphous alloy for the second layers in contact with the T-L composition layers 5 that are the first layers. When the second layers are made of an amorphous material, even if the first layers are of the columnar structure, the growth of the columnar structure is blocked by the second layers, failing in forming continuous columnar structure. If a crystalline material is adopted for the second layers, the first layers each in contact with either surface of any one of the second layers undergo the crystal growth therein affected by the crystal structure of the second layers, unpreferably resulting in forming a continuous columnar structure.

It is preferable that the Co based amorphous alloy layers 3 each have the properties, by itself, such that a permeability is 1000 or more (measurement frequency: 10 MHz), a saturation magnetization is 10 kG (1.0 T) or more, and a resistivity is 100 $\mu\Omega$ cm or more.

The Co based amorphous alloy layers 3 as the second layers of the present invention are formed in such a way that the alloy is mainly composed of Co, and contains the element M, wherein M is at least one element selected from the group consisting of B, C, Si, Ti, V, Cr, Mn, Fe, Ni, Y, Zr, Nb, Mo, Hf, Ta and W, the alloy being mainly constituted as an amorphous phase. The proportion of the additional element (s) (the total proportion when two or more elements are added) is usually set at 5 to 50 at%, preferably 10 to 30 at%. When the proportion of the additional element(s) is too large, there occurs a problem that the saturation magnetization comes to be low, while when the proportion of the additional element (s) is too small, there occurs a problem that the control of the magnetostriction becomes difficult and no effective soft magnetic properties can be obtained.

Examples of the preferable composition systems for constituting the Co based amorphous alloy layers 3 include CoZr, CoHf, CoNb, CoMo, CoZrNb, CoZrTa, CoFeZr, CoFeNb, CoTiNb, CoZrMo, CoFeB, CoZrNbMo, CoZrMoNi, CoFeZrB, CoFeSiB, and CoZrCrMo.

Next, description will be made below on the reason why there can be obtained the magnetic thin film for high frequency 1 which has both a high permeability and a high saturation magnetization by combining the above described T-L composition layers 5 and the above described Co based amorphous alloy layers 3 disposed on either of the surfaces of any one of the T-L composition layers 5.

The magnetic thin film for high frequency 1 of the present invention is suitably used in the frequency ranges of a few 100 MHz or more, in particular, in the high frequency range of 1 GHz or more. The permeability in such a high frequency range (hereinafter, simply referred to as "the high frequency permeability") is related to various physical properties of the sample concerned in a complicated manner. Among such properties are the anisotropic magnetic field and the saturation magnetization that are most closely related to the permeability. In general, the product of the permeability and the resonance frequency has a relation that it is proportional to the (1/2) -th power of the anisotropic magnetic field and the (3/2)-th power of the saturation magnetization. Here, the resonance frequency is represented by the following formula (1):

$$f_r = (\gamma/2\pi) \, [H_k 4\pi M_s]^{1/2} \qquad \text{formula (1)}$$

wherein $f_r$ denotes the resonance frequency, $\gamma$ denotes the gyromagnetic constant, $H_k$ denotes the anisotropic magnetic field and $4\pi M_s$ denotes the saturation magnetization.

Thus, it comes to be possible to raise the frequency limit of application by increasing the anisotropic magnetic field and the saturation magnetization of the material and thereby increasing the resonance frequency of the material. A calculation of the anisotropic magnetic field based on the formula (1), required for improving up to 2 GHz the resonance frequency of a CoZrNb amorphous alloy thin film as a typical example of the conventional Co based amorphous alloy thin films, reveals that an anisotropic magnetic field of 44 Oe (3501 A/m) or more is required. As can be seen from this calculation, it is difficult to apply to the GHz range the film concerned that has usually an anisotropic magnetic field of the order of 15 Oe (1193 A/m).

On the other hand, the anisotropicmagnetic field required for actualizing the resonance frequency of 2 GHz is 36 Oe (2864 A/m) when the saturation magnetization is 14 kG (1.4 ,T), and 28 Oe (2228 A/m) when the saturation magnetization is 18 kG (1.8T) . Thus, it can be expected that the required saturation magnetization and anisotropic magnetic field be actualized by combining a Fe based alloy or a FeCo based alloy that has a high saturation magnetization and a high magnetic crystalline anisotropy.

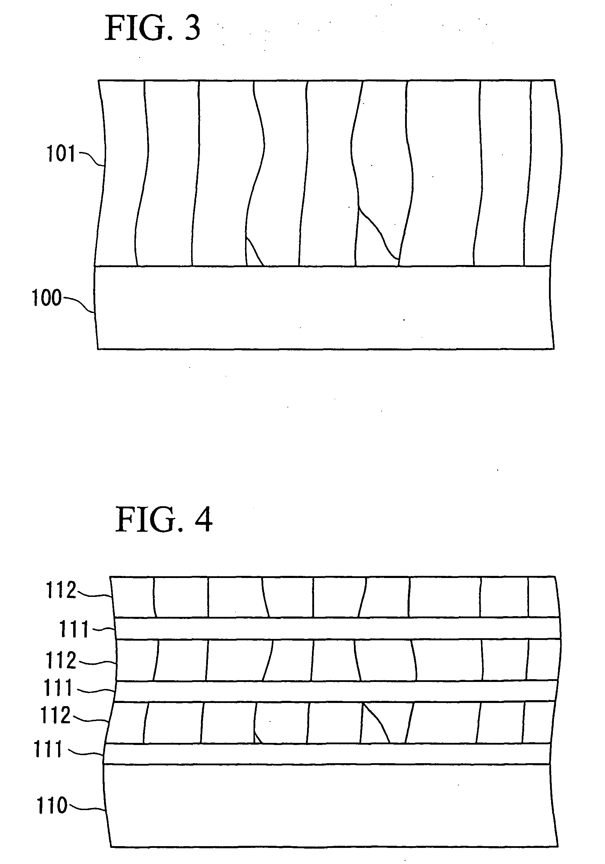

So far, alloys comprising Fe or FeCo as a main component have been well known as materials having high saturation magnetization. However, when a magnetic thin film made of a Fe based alloy or a FeCo based alloy is fabricated by means of a deposition technique such as the sputtering technique, the saturation magnetization of the film obtained is high, but the coercive force thereof is high and the resistivity thereof is low, so that satisfactory high frequency properties thereof can be hardly obtained. The main reason for this is understood as follows: as shown in Figure 3, the Fe based or FeCo based thin film 101 formed by deposition with the aid of sputtering or the like undergoes the columnar growth along the direction perpendicular to the substrate 100, and the generation of the perpendicular magnetic anisotropy originated from the columnar structure has been understood to be problematic.

However, as a result of the diligent study carried out by the present inventors, the following findings have been obtained on the Fe-C thin film in which Fe is added with a predetermined amount of C (carbon).

(1) A Fe-C thin film having a predetermined thickness also has columnar structure, but when the thickness is of the order of 70 nm or less, excellent soft magnetic properties can be obtained because the aspect ratio of the columnar structure (the ratio of the column length to the column width, the length÷the width) is small. More specifically, the mean width of the grown Fe-C columns is about 50 nm, and the degradation of the soft magnetic properties due to the columnar structure can be suppressed as far as the thickness is of the order of 70 nm for which the aspect ratio of the columnar structure is 1.4 or less. For the purpose of obtaining a Fe-C thin film having such an aspect ratio, as shown in Figure 4, it is effective that a Co based amorphous alloy thin film 111 is interposed between a Fe-C thin film 112 and another Fe-C thin film 112. This is because, by adopting this way, the continuous growth of the columnar structure of the Fe-C grains can be prevented.

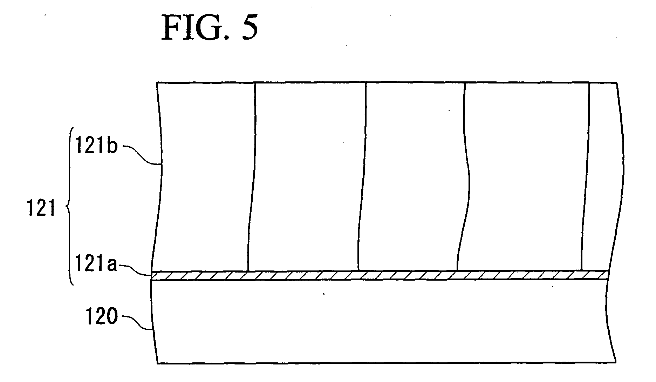

(2) Elaborate examination of the growth process of the Fe-C thin film has revealed that a microcrystalline state of 3 nm or less in crystal grain size is found in the early stage of the film growth with the film thickness of the order of 3 nm or less, and the unstable surface ratio is increased, so that the features of an amorphous substance are manifested. More specifically, as shown in Figure 5, the Fe-C thin film 121 is constituted as an amorphous structure portion 121a formed on the substrate 120 and a columnar structure portion 121b formed on the amorphous structure portion 121a. Being amorphous may be judged for the case of the Fe-C thin film, on the basis of the X-ray diffraction, from the absence of the diffraction peak ascribable to the Fe-C bcc (110) crystal plane. A thin film having such amorphous structure, needless to say, does not turn into columnar structure, and can yield high resistance (100 $\mu\Omega$ cm or more) property attributable to amorphous structure. Accordingly, adoption of a form in which the Fe-C thin films and the Co based amorphous alloy thin films are laminated makes it possible to actualize soft magnetic properties, needless to say, and a high resistance, so that a magnetic thin film high in permeability in the GHz range, suppressed in eddy current loss and high in quality factor can be obtained.

The above described matters (1) and (2) are effective not only for the Fe-C thin film but also for the FeCo-C thin film, and moreover, even for the case where C is replaced with B or N.

On the basis of the above grounds, there can be obtained a magnetic thin film for high frequency 1 having both a high permeability and a high saturation magnetization by disposing each of the Co based amorphous alloy layers 3 having excellent soft magnetic properties on either surface of any one of the T-L composition layers 5 having a high saturation magnetization and a high anisotropic magnetic field. More specifically, a laminate in which the Co based amorphous alloy layers 3 and the T-L composition layers 5 are laminated exhibits the properties such that, at 1 GHz, the real part ($\mu'$) of the permeability is 200 or more, the quality factor Q (Q = $\mu'/\mu''$) is 1 or more and the saturation magnetization is 12 kG (1.2 T) or more.

Next, description will be made below on the high resistance layers 7 disposed on the surface and/or in the interior of the laminate in which the Co based amorphous alloy layers 3 and the T-L composition layers 5 are laminated.

The provision of the high resistance layers 7 as the third layers in the present invention is based on the following grounds. First, the resistivity and the performance of an inductor are closely related to each other, the effect due to skin effect is reduced by increasing the resistivity of the magnetic thin film for high frequency 1, and the performance of the inductor can be thereby improved when the magnetic thin film for high frequency 1 is applied to the inductor.

As the high resistance layers 7, any magnetic substance and any nonmagnetic substance may be used as long as such substances are higher in electric resistance than the T-L composition layers 5 and the Co based amorphous alloy layers 3. More specifically, the high resistance layers 7 each have preferably such properties that the resistivity thereof, by itself, is 300 $\mu\Omega$ cm or more.

In this connection, when the high resistance layers 7 are each constituted of a magnetic substance, for example, a granular structure film may be used. Constitution of the high resistance layers 7 by use of a magnetic substance makes it possible to improve the resistivity while a high saturation magnetization is being maintained. The improvement of the resistivity serves to suppress the eddy current loss in the high frequency range.

On the other hand, when the high resistance layers 7 are each constituted of a nonmagnetic substance, for example, an oxide film, a nitride film, an fluoride film or the like may be used. Constitution of the high resistance layers 7 by use of a nonmagnetic substance makes it possible to obtain a further higher resistivity. The oxide film may be an intentionally formed film, or may also be a spontaneously formed oxide film derived from, for example, the Co based amorphous alloy layer 3 or the T-L composition layer 5 in contact with oxygen. Hereinafter, the oxide film formed in such a way will be referred to as a spontaneous oxide film.

Although as described above it is effective to provide the high resistance layers 7 for the purpose of improving the resistivity, when the proportion of the high resistance layers 7 in the magnetic thin film for high frequency 1 becomes too large, the soft magnetic properties tend to be degraded. Accordingly, the proportion of the high resistance layers 7 is set at 3 to 40 vol%, preferably 3 to 20 vol%, and more preferably 15 vol% or less in terms of the volume ratio in relation to the magnetic thin film for high frequency 1. As described above, the high resistance layers 7 may be constituted of a magnetic substance or a non magnetic substance. In this connection, when the high resistance layers 7 are constituted of a nonmagnetic substance, the proportion of the high resistance layers 7 is preferably set at 10 vol% or less in terms of the volume ratio in relation to the magnetic thin film for high frequency 1. This is for the purpose of preventing the degradation of the soft magnetic properties. On the other hand, when the high resistance layers 7 are constituted of a magnetic substance having a granular structure or the like, the degradation of the soft magnetic properties does not occur even if the proportion of the high resistance layers 7 becomes as large as of the order of 20 vol%.

Examples of the composition system for the case where the high resistance layers 7 are each made to have a granular structure includes an M-X-Z based material, wherein M is at least one element selected from the group consisting of Fe, Co and Ni, X is any one of Mg, Ca, Y, Ti, Zr, Hf, V, Nb, Ta, Cr, Mo, W, Zn, Al and Si, or an admixture thereof, and Z is any one of F, N and O, or an admixture thereof. M may include C and/or B. Specific examples of the composition for the case where the high resistance layers 7 are each made to have a granular structure include FeCoAlO, FeAlO, FeCoSiO, FeCoCZrO, FeNiAlO, CoMgF, FeMgF, FeCoCaF and CoAlN.

When the high resistance layers 7 are each constituted of an oxide film, a film of an oxide such as $Al_2O_3$ or $SiO_2$ may be adopted; when the high resistance layers 7 are each constituted of a nitride film, a film of a nitride such as AlN or $Si_3N_4$ may be adopted; and when the high resistance layers 7 are each constituted of a fluoride film, a film of a fluoride such as $MgF_2$ or $CaF_2$ may be adopted.

In the present invention, the thickness (T3) of each of the high resistance layers 7 is set at 20 nm or less, preferably at 15 nm or less, and more preferably at 10 nm or less. A high resistivity can be obtained as far as the proportion of the high resistance layers 7 in the magnetic thin film for high frequency 1 falls within the above described range, whereas when the T3 value comes to be less than 0.5 nm, the number of laminating operations is increased to cause a problem in production that the deposition time is elongated. Accordingly, T3 is set preferably at 0.5 nm or more, and more preferably at 1.0 nm or more.

In principle, according to the desired properties, the type of the high resistance layers 7 may be selected and the proportion of the high resistance layers 7 and the thickness (T3) of each thereof may also be determined.

By constituting the magnetic thin film for high frequency 1 by using the T-L composition layers 5, the Co based amorphous alloy layers 3 and the high resistance layers 7, there can be obtained a magnetic thin film for high frequency in which the real part ($\mu'$) of the complex permeability thereof is 400 or more at 1 GHz, the quality factor Q ($Q = \mu'/\mu''$) thereof is 20 or more and the saturation magnetization thereof is 14 kG (1.4 T) or more. In addition, even such a high resistivity as 200 $\mu\Omega$ cm can be obtained under the condition that such high magnetic properties are being maintained. It is to be noted that the real part ($\mu'$) of the permeability is desired to take a value as high as possible in the GHz range (at 1 GHz), with no particular upper limit to be imposed thereon. Similarly, the saturation magnetization is also desired to take a value as high as possible, with no particular upper limit to be imposed thereon. Additionally, although there is no particular upper limit to be imposed on the resistivity, the upper limit thereof is preferably set approximately at 1000 $\mu\Omega$ cm or less from the viewpoint that a too large proportion of the high resistance impairs the soft magnetic properties and the high saturation magnetization properties.

Next, description will be made below on the preferable thicknesses of the T-L composition layers 5 and the Co based amorphous alloy layers 3. When the thickness of each of the T-L composition layers 5 is denoted by T1 and the thickness of each of the Co based amorphous alloy layers 3 is denoted by T2, it is effective that T1 is set to fall within the range of 3 to 70 nm, and T1/T2 is set to fall within the range of 0.15 to 3.50, and preferably within the range of 0.25 to 2.50. When this value exceeds 3.50, columnar structure is manifested at the time of deposition of the T-L composition layers 5, and the anisotropic magnetic field and the coercive force (Hch) along the hard magnetization axis are sharply increased, generating the perpendicular magnetic anisotropy. Consequently, there occurs a problem that satisfactory soft magnetic properties cannot be obtained. On the other hand, when this value is smaller than 0.15, a saturation magnetization of 1.4 kG (1.4 T) or more cannot be obtained. Accordingly, T1/T2 is preferably set at 0.15 to 3.50 when the thickness T1 of each of the T-L composition layers 5 falls within the range from 3 to 70 nm.

Additionally, when the thickness of each of the T-L composition layers 5 is denoted by T1 and the thickness of each of the Co based amorphous alloy layers 3 is denoted by T2, it is also effective that T1 is set to fall within the range of 0.5 to 3.0 nm, and T1/T2 is set to fall within the range of 0.8 to 3.0.

When T1/T2 exceeds 3.0, the FeC particles grow large, and it becomes difficult to obtain such a high resistivity as 200 $\mu\Omega$ cm or more even when the presence of the high resistance layers 7 is taken into account. On the other hand, when T1/T2 is less than 0.8, the proportion of the T-L composition layers 5 provided with high saturation magnetization becomes low, and the shift of the resonance frequency to the higher frequencies becomes difficult. The preferable value of T1/T2 is 1.0 or more and 2.5 or less.

By making T1 and T1/T2 respectively fall within the ranges of the present invention and by controlling the proportion of the high resistance layers 7 within the above described range, it is made possible to actualize a composite magnetic thin film having excellent properties such that the resistivity is 200 $\mu\Omega$ cm or more, the real part ($\mu'$) of the complex permeability at 1 GHz is 300 or more, the quality factor ($Q = \mu'/\mu''$) is 10 or more and the saturation magnetization is 14 kG (1.4 T) or more. It is to be noted that as described above, the measurements of these properties are made for the thin films as deposited without being subjected to heat treatment and the like.

In the magnetic thin film for high frequency 1 of the present invention, no particular constraint is imposed on the total number of laminating operations of the T-L composition layers 5, the Co based amorphous alloy layers 3 and the high resistance layers 7, but the total number of laminating operations is usually 5 to 3000, and preferably about 10 to 700. In the magnetic thin film for high frequency 1, the same type (the T-L composition layer 5, the Co based amorphous alloy layer 3, or the high resistance layer 7) films are usually formed so as to have the same thickness. However, in some rare cases, it is possible that even the same type films in a particular laminating portion are made to be different in deposition thickness from the same type films in other laminating portions depending on the laminating portions. Thus, there can be such a specification, as an extreme case, that the film thickness of the T-L composition layer 5 in the vicinity of the center is set at 20 nm, and the thickness of each of the two T-L composition layers 5 respectively in the top portion and the bottom portion is set at 5 nm, as the case may be. In such a case, the film thickness for the T-L composition layers 5 in the present invention may be derived as an arithmetic mean thickness (Tf). In the above described example, the arithmetic mean value, Tf = 10 nm, is adopted, and for example, Tf/Tc (Tc is the arithmetic mean value of the film thicknesses of the Co based amorphous alloy layers 3) may be derived therefrom. Additionally, the magnetic thin film for high frequency 1 of the present invention admits the disposition of layers other than the Co based amorphous alloy layers 3, the T-L composition layers 5 and the high resistance layers 7.

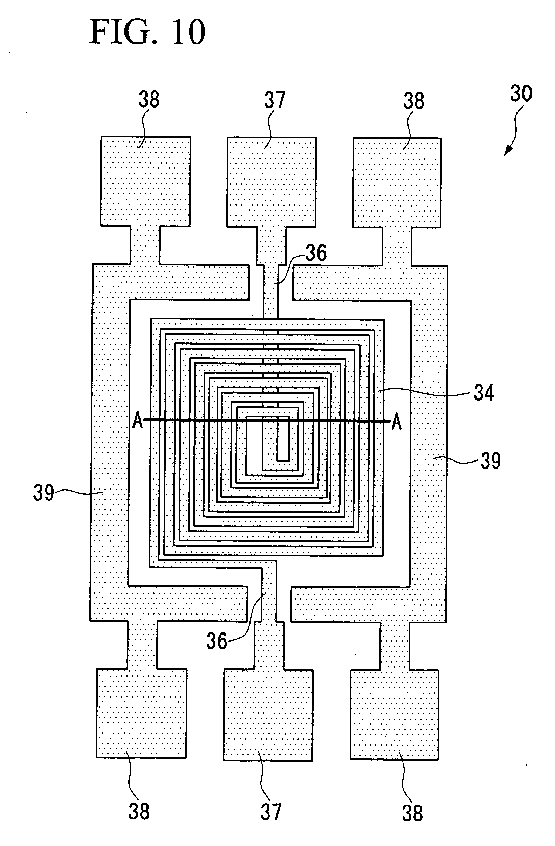

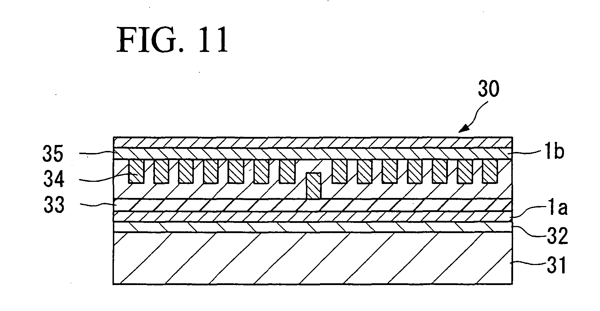

The thickness of such a magnetic thin film for high frequency 1 of the present invention is set at 200 to 3000 nm, and preferably at 300 to 2000 nm. When this value is smaller than 200 nm, there can occur a problem that the magnetic thin film cannot carry a desired power when applied to a planar magnetic device, and additionally, there can also occur a problem that the advantageous effect of the magnetic thin film cannot be fully displayed in such a way that, as a mode of a core coil provided with the magnetic thin films shown in Figures 10 and 11 to be described later, there is found a tendency such that the inductance increment as compared to an air-core coil is less than 10%. On the other hand, when this value exceeds 3000 nm, the high frequency loss due to skin effect becomes remarkable, causing a problem that the loss in the GHz range is increased.

It is preferable that the magnetic thin film for high frequency 1 of the present invention is formed by means of a vacuum thin film formation method, in particular, the sputtering technique. More specifically, there are used the RF sputtering, DC sputtering, magnetron sputtering, ion beam sputtering, induction coupled RF plasma assisted sputtering, ECR sputtering, faced-targets sputtering, multi-target simultaneous sputtering and the like.

As the target for forming the Co based amorphous alloy layers 3, a composite target may be used in which on a Co target, pellets of a desired additional element is arranged, and a target of a Co alloy containing a desired additional component may be used.

As the target for forming the T-L composition layers 5, a composite target may be used in which on a Fe (or a Fe-Co alloy) target pellets of an element L is arranged, or a target of an alloy composed of Fe (or FeCo) and the element L may be used. The concentration regulation for the element L may be made, for example, by regulating the amount of the pellets of the element L.

As the target for forming the high resistance layers 7 having a granular structure, a composite target may be used in which on a Fe (or Ni, Co, FeCo alloy or the like) target, the pellets of the element X and the pellets of the element Y are arranged, or a target of an alloy composed of the element X, the element Y and Fe (or Ni, Co, FeCo alloy or the like) may be used.

It may be noted that the sputtering is merely one mode of the present invention, and needless to say, other thin film formation processes may be applicable. As for the specific deposition method for the magnetic thin film for high frequency 1 of the present invention, Examples to be described later may be referred to.

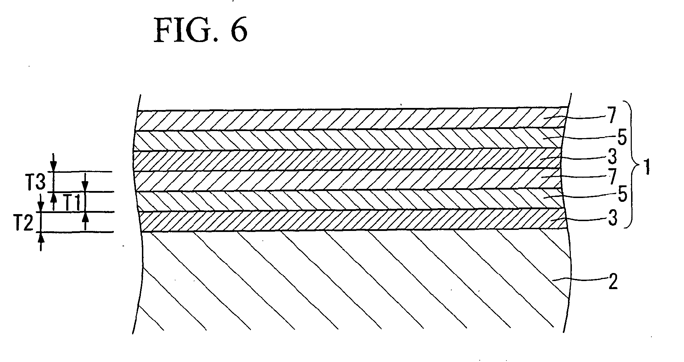

In the above, by referring to Figure 1 and the like, description has been made on the configuration and the features of the magnetic thin film for high frequency 1 of the present invention having a multilayer film configuration in which a plurality of the Co based amorphous alloy layers 3, a plurality of the T-L composition layers 5 and a plurality of the high resistance layers 7 are laminated. Figure 1 shows a laminating configuration (laminating period) in which the two Co based amorphous alloy layers 3 and the two T-L composition layers 5 are alternately laminated and then the one high resistance layer 7 is disposed, but the laminating configuration is not limited to this case. In other words, the high resistance layer 7 may be disposed repeatedly every time when the Co based amorphous alloy layers 3 and the T-L composition layers 5 are alternately laminated a predetermined number of times. For example, when the predetermined number of times is 1, the Co based amorphous alloy layer 3, the T-L composition layer 5 and the high resistance layer 7 are successively laminated, as shown in Figure 6. On the other hand, in a case where the predetermined number of times is 3, the high resistance layer 7 is once disposed when the Co based amorphous alloy layers 3 and the T-L composition layers 5 are alternately laminated three times to result in a total number of the layers amounting to 6.

The above described laminating period is shown as formula (2) :

$$[\{(T2/T1) \times n\}/T3] \times m \qquad \text{formula (2)}$$

wherein, as described above, T2 denotes the thickness of each of the Co based amorphous alloy layers 3, T1 denotes the thickness of each of the T-L composition layers 5 and T3 denotes the thickness of each of the high resistance layers 7. In formula (2), each of the symbols "/" does not mean a fraction. In other words, for example, "T2/T1" does not mean the T2 value is divided by the T1 value, but means that the Co based amorphous alloy layers 3 and the T-L composition layers 5 are laminated in a manner being made to contact with each other.

Further, n denotes "the predetermined number of times" as referred to in the present invention. In the present invention, it is recommended to satisfy the expression that n = 1 to 5. When n exceeds 5, it comes to be difficult to reduce the high frequency loss due to skin effect even if the values of T2 and T1 are made small.

In formula (2), m is a coefficient to be optionally set so that the total thickness of the magnetic thin film for high frequency 1 may amount to 200 to 2000 nm.

Accordingly, when n = 2, as shown in Figure 1, the two Co based amorphous alloy layers 3 and the two T-L composition layers 5 are alternately laminated, and then the one high resistance layer 7 is laminated. Now, it is assumed that the thickness T1 of each of the T-L composition layers 5, the thickness T2 of each of the Co based amorphous alloy layers 3, and the thickness T3 of each of the high resistance layers 7 are all 1.0 nm. In this case, a thickness amounting to 5.0 nm is obtained by passing through one cycle such that the two Co based amorphous alloy layers 3 and the two T-L composition layers 5 are alternately laminated, and then the one high resistance layer 7 is laminated. Accordingly, for the purpose of setting the total thickness of the magnetic thin film for high frequency 1 to fall within the range of 200 to 2000 nm, m is set to fall within the range of 40 to 400.

By adopting the laminating period given by formula (2), it comes to be possible to set the skin depth at 1 GHz at 1.0 μm or more in the magnetic thin film for high frequency 1 comprising the Co based amorphous alloy layers 3, the T-L composition layers 5 and the high resistance layers 7. Here, the skin depth is represented by following formula (3). In formula (3), δ denotes the skin depth, ω denotes the angular frequency, μ denotes the permeability, and σ denotes the electric conductivity.

$$\delta = \sqrt{\frac{2}{\omega\mu\sigma}} \qquad \text{formula (3)}$$

In the above, by referring to formula (2), description has been made on the laminating period; however, such a description involves only one example, and is not intended to exclude other laminating periods. For example, as shown below as examples, a first cycle (n = 2) and a second cycle (n = 3) may be alternately repeated, n also being able to be varied optionally.

(Example)

First cycle (n = 2)

The two Co based amorphous alloy layers 3 and the two T-L composition layers 5 are alternately laminated, and then the one high resistance layer 7 is laminated.

Second cycle (n = 3)

The three Co based amorphous alloy layers 3 and the three T-L composition layers 5 are alternately laminated, and then the one high resistance layer 7 is laminated.

Here, the Co based amorphous alloy layer 3 is denoted by (3), the T-L composition layer 5 is denoted by (5), and the high resistance layer 7 is denoted by (7) ; the laminating configuration in which the first cycle (n = 2) and the second cycle (n = 3) are alternately repeated twice is shown below: (3) (5) (3) (5) (7) (3) (5) (3) (5) (3) (5) (7) (3) (5) (3) (5) (7) (3) (5) (3) (5) (3) (5) (7)

Next, description will be made below on a substrate 2 on which the magnetic thin film for high frequency 1 of the present invention is formed.

Examples of the substrate 2 (Figure 1) on which the magnetic thin film for high frequency 1 of the present invention is formed include glass substrate, ceramic material substrate, semiconductor substrate and resin substrate. Examples of the ceramic material include alumina, zirconia, silicon carbide, silicon nitride, aluminum nitride, steatite, mullite, cordierite, forsterite, spinel and ferrite. It is preferable that, among these materials, aluminum nitride is used which is high both in thermal conductivity and in bending strength.

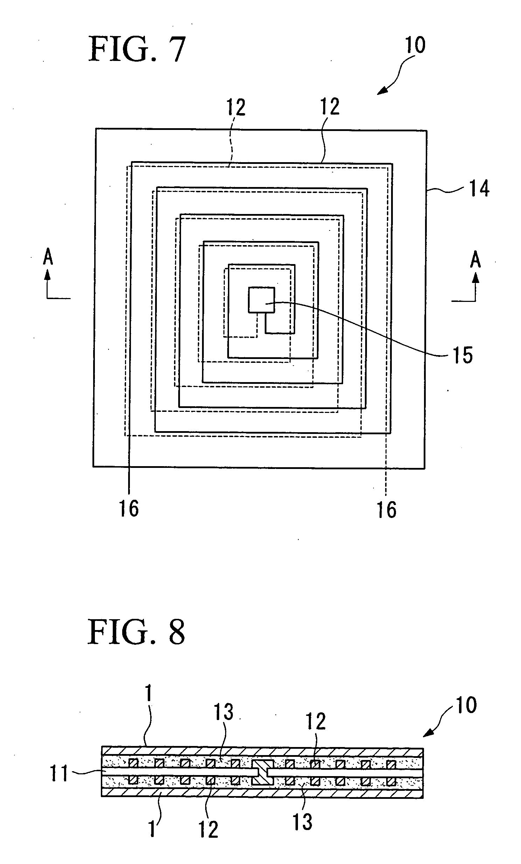

Additionally, the magnetic thin film for high frequency 1 of the present invention has, as described above, extremely excellent high frequency properties and can display the performance thereof as deposited at room temperature, and accordingly, the magnetic thin film is a material most suitable for high frequency integrated circuits such as MMICs fabricated by means of the semiconductor processes. Thus, examples of a substrate 11, a substrate 21 and a substrate 31 (shown in Figures 8, 9 and 11 to be described later) include semiconductor substrates such as Si, GaAs, InP and SiGe substrates. Needless to say, the magnetic thin film for high frequency 1 of the present invention may be deposited on various ceramic material substrates and resin substrates.

Successively, specific examples of magnetic devices to which the magnetic thin film for high frequency 1 of the present invention is applied will be presented below.

An example of a planar magnetic device applied to an inductor is shown in Figures 7 and 8. Figure 7 schematically shows a plan view of the inductor, and Figure 8 schematically shows a cross-sectional view along the A-A line in Figure 7.

The inductor 10 shown in these figures comprises the substrate 11, planar coils 12, 12 formed in spiral shape on both surfaces of the substrate 11, insulating films 13, 13 formed so as to cover these planar coils 12, 12 and the substrate 11, and a pair of the magnetic thin films for high frequency 1 of the present invention formed so as to cover the respective insulating films 13, 13. Additionally, the two above described planar coils 12, 12 are electrically connected to each other through the intermediary of a through hole 15 formed in an approximately central location on the substrate 11. Furthermore, from the planar coils 12, 12 on both surfaces of the substrate 11, terminals 16 for connection are extended so as to be accessible from the outside. Such an inductor 10 is constituted in such a way that a pair of the magnetic thin films for high frequency 1 sandwich the planar coils 12, 12 through the intermediary of the insulating films 13, 13, so that an inductor is formed between the connection terminals 16, 16.

The inductor formed in this way is small and thin in shape and light in weight, and exhibits excellent inductance particularly in the high frequency range of 1 GHz or above.

Additionally, in the above described inductor 10, a transformer can be formed by arranging a plurality of the planar coils 12 in a parallel manner.

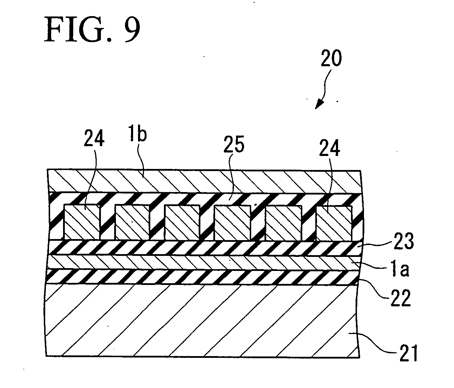

Figure 9 shows another preferred embodiment in which the planar magnetic device of the present invention is applied to an inductor. Figure 9 schematically shows a cross-sectional view of the inductor. As shown in Figure 9, an inductor 20 comprises a substrate 21, an oxide film 22 formed according to need on the substrate 21, a magnetic thin film 1a of the present invention formed on the oxide film 22, and an insulating film 23 formed on the magnetic thin film 1a, and furthermore, has a planar coil 24 formed on the insulating film 23, an insulating film 25 formed so as to cover the planar coil 24 and the insulating film 23, and a magnetic thin film for high frequency 1b of the present invention formed on the insulating film 25. The inductor 20 formed in this way is also small and thin in shape and light in weight, and exhibits excellent inductance particularly in the high frequency range of 1 GHz or above. Additionally, in the inductor 20 as described above, a transformer can be formed by arranging a plurality of the planar coils 24 in a parallel manner.

In this connection, the planar magnetic devices such as the thin film inductors are demanded to provide the optimal permeability according to the design specifications for respective devices. The permeability in the high frequency range is highlycorrelatedwith the anisotropic magnetic field, and is proportional to the reciprocal of the anisotropic magnetic field. For the purpose of actualizing high permeability in the high frequency range, it is necessary that the magnetic thin film has an in-plane uniaxial magnetic anisotropy. In the planar magnetic devices such as the thin film inductors, it can be expected that the higher is the saturation magnetization of a magnetic thin film, the more the DC superposition properties are improved. Consequently, the magnitude of the saturation magnetization can be said to be an important parameter in the design of the magnetic thin film for high frequency 1.

Figures 10 and 11 show an example in which the magnetic thin film for high frequency 1 of the present invention is applied as an inductor for use in an MMIC.

Figure 10 is a schematic plan view showing the conductor layer portion extracted from the inductor, and Figure 11 is a schematic cross-sectional view along the A-A line in Figure 10.

An inductor 30 illustrated by these figures comprises, as Figure 11 shows, a substrate 31, an insulating oxide film 32 formed according to need on the substrate 31, a magnetic thin film for high frequency 1a of the present invention formed on the insulating oxide film 32, and an insulating film 33 formed on the magnetic thin film for high frequency 1a, and furthermore, has a spiral coil 34 formed on the insulating film 33, an insulating film 35 formed so as to cover the spiral coil 34 and the insulating film 33, and a magnetic thin film for high frequency 1b of the present invention formed on the insulating film 35.

Additionally, the spiral coil 34 is connected to a pair of electrodes 37 through the intermediary of the wires 36 as shown in Figure 10. A pair of ground patterns 39 arranged so as to surround the spiral coil 34 are respectively connected to a pair of ground electrodes 38, thus forming a shape in which the frequency properties are evaluated on a wafer by means of a ground-signal-ground (G-S-G) type probe.

The inductor for use in an MMIC according to the shape of the present embodiment adopts a core structure in which the spiral coil 34 is sandwiched by the magnetic thin films for high frequency 1a, 1b to form the magnetic core. Consequently, the inductance is improved by about 50% when compared with an inductor with air core structure in which the spiral coil 34 has the same shape but the magnetic thin films for high frequency 1a, 1b are not formed. Thus, the area occupied by the spiral coil 34 which is needed for attaining the same inductance can be made smaller, and consequently the miniaturization of the spiral coil 34 can be actualized.

In this connection, the material for the magnetic thin film applied to the inductors for use in an MMIC is required to have a high permeability in the GHz range and a high quality factor Q (low loss) property and to permit the integration through the semiconductor fabrication process.

For the purpose of actualizing the high permeability in the GHz range, materials high in resonance frequency and high in saturation magnetization are advantageous, and the control of the uniaxial magnetic anisotropy is necessary. Additionally, for the purpose of attaining a high quality factor Q, the suppression of the eddy current loss with the aid of high resistance is important. Furthermore, for the purpose of application to the integration process, it is desirable that deposition can be performed at room temperature, and the films thus formed can be used as deposited. This is because the performances and the fabrication process of the other on-chip components that have already undergone setting are made to be free from the possible adverse effects caused by heating.

(Examples)

Now, further detailed description will be made below on the present invention with reference to specific examples.

[Example 1]

The magnetic thin film for high frequency of the present invention was prepared on the basis of the following deposition method.

(Deposition procedure)

A Si wafer with a 100 nm thick $SiO_2$ deposited thereon was used as the substrate.

By use of a multi-target simultaneous sputtering apparatus, a magnetic thin film for high frequency was deposited on the substrate in a manner to be described later. More specifically, the interior of the multi-target simultaneous sputtering apparatus was preliminarily evacuated down to $8 \times 10^{-5}$ Pa, thereafter Ar gas was introduced until the pressure of the interior reached 10 Pa, and the surface of the substrate was subjected to sputtering etching at an RF power of 100 W for 10 minutes.

Subsequently, the Ar gas flow rate was adjusted so as for the pressure to be 0.4 Pa, at a power of 300 W, a $Co_{87}Zr_5Nb_8$ target, a composite target composed of a Fe target and C (carbon) pellets arranged thereon and a composite target composed of a FeCo target and $Al_2O_3$ (alumina) arranged thereon were repeatedly subjected to sputtering, and thus a composite magnetic thin film was deposited as the magnetic thin film for high frequency formed according to the specifications to be described later.

At the time of deposition, a DC bias of 0 to -80 V was applied to the substrate. For the purpose of preventing the effects caused by impurities on the surfaces of the targets, the presputtering was conducted for 10 minutes or longer with a shutter in a closed condition. Thereafter, with the shutter opened, the deposition onto the substrate was carried out. The deposition rates were set at 0.33 nm/sec for the CoZrNb layer deposition, 0.27 nm/sec for the Fe-C (carbon concentration: 5 at%) layer deposition and 0.12 nm/sec for the FeCoAlO (Fe: 55.2 at%, Co: 24.8 at%, and Al: 20 at%) layer deposition. By controlling the opening and closing times of the shutter, the film thicknesses of the respective layers were regulated.

(Deposition cycle)

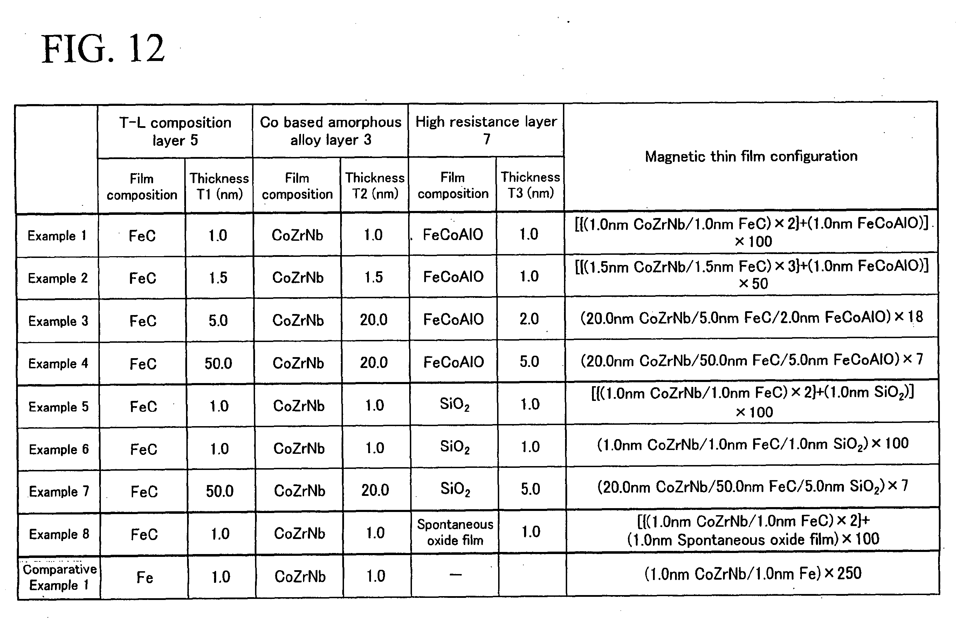

There was repeated twice a deposition cycle in which a 1.0 nm thick CoZrNb layer was deposited as a first layer on the substrate, and thereafter a 1.0 nm thick Fe-C layer was deposited thereon as a second layer. Successively, a 1.0 nm thick FeCoAlO layer was deposited on the fourth layer. There was repeated by 100 cycles a deposition treatment cycle in which, as described above, the two CoZrNb layers and the two Fe-C layers were alternately laminated and thereafter the one FeCoAlO layer was laminated, and thus there was obtained a composite magnetic thin film (Example 1) having a magnetic thin film configuration shown in Figure 12 (the total thickness: 500 nm). The resistivities of Fe-C, CoZrNb and FeCoAlO are respectively shown below:

Fe-C: 40 $\mu\Omega$ cm (carbon concentration: 5 at%) to 70 $\mu\Omega$ cm (carbon concentration: 7 at%)
CoZrNb: 120 $\mu\Omega$ cm
$(Fe_{55.2}Co_{24.8}Al_{20})$ O: 600 $\mu\Omega$ cm

[Example 2]

(Deposition cycle)

There was repeated three times a deposition cycle in which a 1.5 nm thick CoZrNb layer was deposited as a first layer on the substrate, and thereafter a 1.5 nm thick Fe-C layer was deposited thereon as a second layer. Successively, a 1.0 nm thick FeCoAlO layer was deposited on the sixth layer. There was repeated by 50 cycles a deposition treatment cycle in which, as described above, the three CoZrNb layers and the three Fe-C layers were alternately laminated and thereafter the one FeCoAlO layer was laminated, and thus there was obtained a composite magnetic thin film (Example 2) having a magnetic thin film configuration shown in Figure 12 (the total thickness: 500 nm) . The deposition procedures were the same as in Example 1 described above.

[Example 3]

(Deposition cycle)

A 20.0 nm thick CoZrNb layer was deposited as a first layer on the substrate, and thereafter a 5.0 nm thick Fe-C layer was deposited thereon as a second layer. Successively, a 2.0 nm thick FeCoAlO layer was deposited on the Fe-C layer. There was repeated by 18 cycles a deposition treatment cycle in which, as described above, the CoZrNb layer, the Fe-C layer and the FeCoAlO layer were alternately laminated, and there was obtained a composite magnetic thin film (Example 3) having a magnetic thin film configuration shown in Figure 12 (the total thickness: 486 nm). The deposition procedures were the same as in Example 1 described above.

[Example 4]

(Deposition cycle)

A 20.0 nm thick CoZrNb layer was deposited as a first layer on the substrate, and thereafter a 50.0 nm thick Fe-C layer was deposited thereon as a second layer. Successively, a 5.0 nm thick FeCoAlO layer was deposited on the Fe-C layer. There was repeated by 7 cycles a deposition treatment cycle in which, as described above, the CoZrNb layer, the Fe-C layer and the FeCoAlO layer were alternately laminated, and there was obtained a composite magnetic thin film (Example 4) having a magnetic thin film configuration shown in Figure 12 (the total thickness: 525 nm). The deposition procedures were the same as in Example 1 described above.

[Example 5]

In any one of above Examples 1 to 4, FeCoAlO layers were used as the high resistance layers 7, but in Example 5, $SiO_2$ was used for the high resistance layers 7 in place of the FeCoAlO layers.
A composite magnetic thin film (Example 5) having a magnetic thin film configuration shown in Figure 12 (total thickness: 500 nm) was obtained by passing through the same deposition procedures and the same deposition cycles as in Example 1 except that $SiO_2$ was used for the high resistance layers 7 and a $SiO_2$ target was used as a target for forming the high resistance layers 7. The resistivity of $SiO_2$ by itself is shown below:

$SiO_2$: up to approximately $10^{12}$ $\Omega$ cm

[Example 6]

In the same manner as in Example 5, $SiO_2$ was used for the high resistance layers 7 in place of the Fe-CoAlO layers.

(Deposition cycle)

A 1.0 nm thick CoZrNb layer was deposited as a first layer on the substrate, and thereafter a 1.0 nm thick Fe-C layer was deposited thereon as a second layer. Successively, a 1.0 nm thick $SiO_2$ layer was deposited on the Fe-C layer. There was repeated by 100 cycles a deposition treatment cycle in which, as described above, the CoZrNb layer, the Fe-C layer and the $SiO_2$ layer were alternately laminated, and there was obtained a composite magnetic thin film (Example 6) having a magnetic thin film configuration shown in Figure 12 (the total thickness: 300 nm).

[Example 7]

In the same manner as in Example 5, $SiO_2$ was used for the high resistance layer 7 in place of the Fe-CoAlO layer.

(Deposition cycle)

A composite magnetic thin film (Example 7) having a magnetic thin film configuration shown in Figure 12 (total thickness: 525 nm) was obtained by passing through the same deposition procedures and the same deposition cycles as in Example 4 except that $SiO_2$ was used for the high resistance layers 7 and a $SiO_2$ target was used as a target for forming the high resistance layers 7.

[Example 8]

A spontaneous oxide film was used for the high resistance layers 7 in place of the FeCoAlO layers (Examples 1 to 4) and the $SiO_2$ layers (Examples 5 to 7). The spontaneous oxide film was formed according to the following procedures.

(Procedures for forming the spontaneous oxide film)

The spontaneous oxide film was formed by introducing $O_2$ gas at 20 sccm for 20 seconds, after the respective metal layers had been deposited, into the interior of the sputtering apparatus to oxidize the surface of the metal layers. After the spontaneous oxide film had been formed, the sputtering apparatus was evacuated down to a level of $10^{-4}$ Pa. The subsequent steps for laminating were carried out under the same conditions as in Example 1.

A composite magnetic thin film (Example 8) having a magnetic thin film configuration shown in Figure 12 (total thickness: 500 nm) was obtained by passing through the same deposition procedures and the same deposition cycles as in Example 1 except that the spontaneous oxide layers were used for the high resistance layers 7 and no target for forming the high resistance layers 7 was needed.

[Comparative Example 1]

The Fe-C layers in above described Example 1 were replaced with Fe layers. Without including FeCoAlO layers, the CoZrNb layers and the Fe-C layers were alternately laminated to form a composite magnetic thin film of a comparative example (Comparative Example 1). In order to obtain the same total thickness (500 nm) as in Example 1, the number of laminating operations for the CoZrNb layers and the number of laminating operations for the Fe layers were both set at 250.

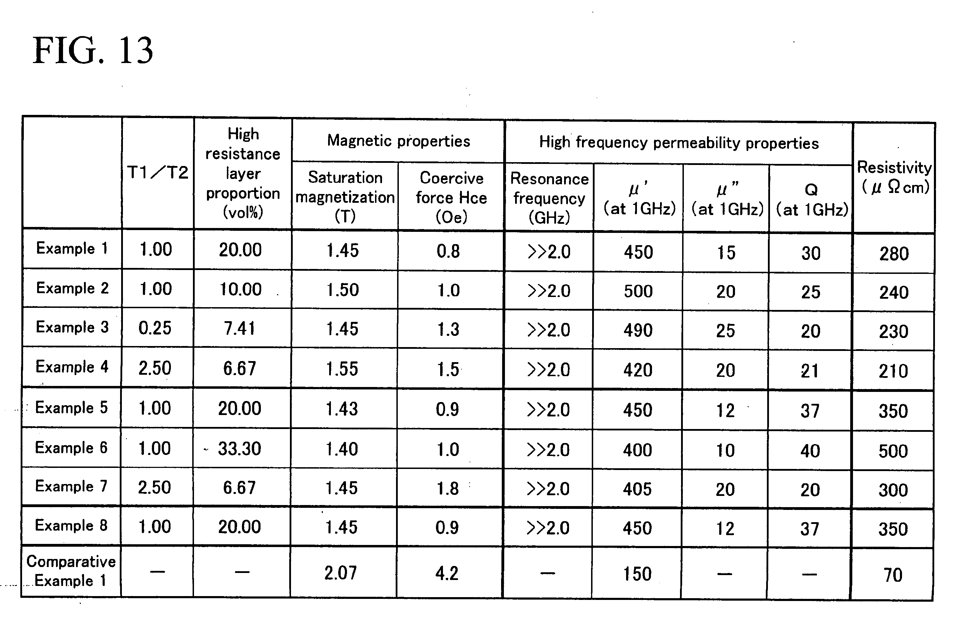

The magnetic properties, the high frequency permeability properties and the resistivitys of the composite magnetic thin films obtained in Examples 1 to 8 and Comparative Example 1 were measured. The results obtained are shown in Figure 13. The high frequency permeability measurement was made by use of a thin film high frequency permeability measurement apparatus (Naruse Kagakukiki Co. , PHF-F1000), and the magnetic properties were measured by use of a vibrating sample magnetometer (Riken Denshi Co., Ltd., BHV-35). The resistivities were measured by use of a four-probe resistor (Microswiss, equipped with four-probe head, NPS, $\Sigma$-5). For each of Examples 1 to 8, the proportion (vol%) of the high resistance layers 7 in the composite magnetic thin film is also shown in Figure 13.

As shown in Figure 13, each of Examples according to the present invention can be provided with such properties that the saturation magnetization thereof is 14 kG (1.4 T) or more, the resonance frequency thereof is 2.0 GHz or more, the real part ($\mu$') of the permeability thereof at 1 GHz is 400 or more, the Q value thereof is 20 or more and the resistivity thereof is 200 $\mu\Omega$ cm or more. Consequently, it has been found that the FeCoAlO layers, the $SiO_2$ layers and the spontaneous oxide layers, used in each of Examples according to the present invention, are effective for the purpose of improving the resistivity without impairing the magnetic properties and the high frequency permeability properties. In this connection, it attracts the attention that among Examples 1 to 8, Examples 1, 2, 5, 6 and 8 of Examples each having a T1 value falling within the range of 0.5 to 3 nm and a T1/T2 value falling within the range of 0.8 to 3.0 each have acquired a saturation magnetization of 1.4 kG (1.4 T) or more and a Q value of 25 or more. Additionally, Examples 1 to 4, in each of which the high resistance layers 7 were formed of FeCoAlO that was a type of granular structure film, each has exhibited such satisfactory magnetic properties and high frequency permeability properties that the saturation magnetization thereof is 14.5 kG (1.45 T) or more and the real part ($\mu$') of the permeability thereof at 1 GHz is 400 or more while exhibiting a resistivity of 200 $\mu\Omega$ cm or more.

On the other hand, in Comparative Example 1 in which no high resistance layers 7 were formed, such an insufficient resistivity as 70 $\mu\Omega$ cm was exhibited; the real part ($\mu$') of the permeability thereof at 1 GHz was 150, but the permeability value was low and hence the measured value of $\mu$" was poor in reliability, so that the quality factor Q ($Q = \mu'/\mu$") was not able to be obtained.

Investigation of the structure of each of the composite magnetic thin films obtained in Examples 1 to 8 has revealed the following findings.

(On Examples 1, 2, 5, 6 and 8)

In each of Examples 1, 2, 5, 6 and 8, the thickness of each of the Fe-C layers was 1.0 to 1.5 nm. By investigating the structure of each of the composite magnetic thin films of these Examples by means of X-ray diffraction, the Fe-C layers and the CoZrNb layers were both identified as amorphous.

(On Examples 4 and 7)

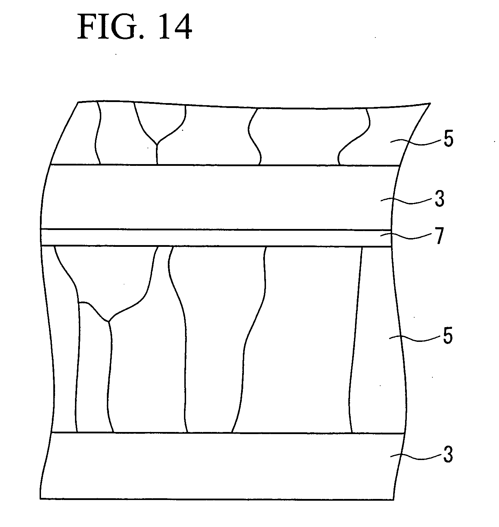

In each of Examples 4 and 7, the thickness of each of the Fe-C layers was 50.0 nm. By investigating the structure of each of the composite magnetic thin films of these Examples, the Fe-C layers were identified to be mainly composed of columnar crystal grains and the aspect ratio for the columnar structure portion was identified to be 1.4 or less. Additionally, the CoZrNb layers were identified as amorphous. A schematic cross-sectional view of the composite magnetic thin films obtained in Example 4 is shown in Figure 14.

(On Example 3)

In Example 3, the thickness of each of the Fe-C layers was 5.0 nm. By investigating the structure of the composite magnetic thin film of this Example, the Fe-C layers were identified to be constituted of the aforementioned amorphous structure portion and the columnar structure portion formed thereon, and the aspect ratio of the columnar structure portion was identified to be 1.4 or less. Additionally, the CoZrNb layers were identified as amorphous.

[Example 9]

A composite magnetic thin film (Example 9) of the present invention was formed in the same manner as in Example 1 except that the Fe-C layers in Example 1 were replaced with Fe-B layers.

[Example 10]

A composite magnetic thin film (Example 10) of the present invention was formed in the same manner as in Example 3 except that the Fe-C layers in Example 3 were replaced with Fe-B layers.

[Example 11]

A composite magnetic thin film (Example 11) of the present invention was formed in the same manner as in Example 5 except that the Fe-C layers in Example 5 were replaced with Fe-B layers.

[Example 12]

A composite magnetic thin film (Example 12) of the present invention was formed in the same manner as in Example 7 except that the Fe-C layers in Example 7 were replaced with Fe-B layers.
In each of Examples 9 to 12, the Fe-B layers were formed by use of a $Fe_{95}B_5$ alloy target.

[Example 13]

A composite magnetic thin film (Example 13) of the present invention was formed in the same manner as in Example 1 except that the Fe-C layers in Example 1 were replaced with Fe-B-N layers. The Fe-B-N layers were formed by use of a $Fe_{95}B_5$ alloy target and also by introducing N gas into the interior of the chamber in the sputtering apparatus while sputtering was being carried out.

[Example 14]

A composite magnetic thin film (Example 14) of the present invention was formed in the same manner as in Example 1 except that the Fe-C layers in Example 1 were replaced with Fe-B-C layers. The Fe-B-C layers were formed by use of a $Fe_{95}B_5$ alloy target.

[Example 15]

A composite magnetic thin film (Example 15) of the present invention was formed in the same manner as in Example 1 except that the Fe-C layers in Example 1 were replaced with Fe-C-N layers. The Fe-C-N layers were formed by introducing N gas into the interior of the chamber in the sputtering apparatus while sputtering was being carried out.

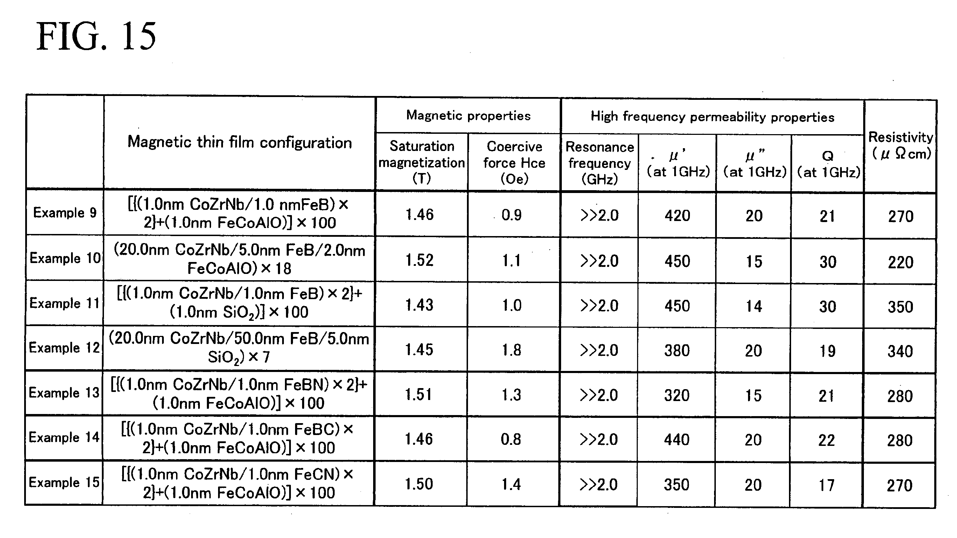

The magnetic properties, the high frequency permeability properties and the resistivitys of the composite magnetic thin films obtained in Examples 9 to 15 were measured. The results obtained are collectively shown in Figure 15. The measurement conditions for the magnetic properties, the high frequency permeability properties and the resistivitys were the same as described above.

As can be seen from Examples 9 to 15 in Figure 15, not only C but B and/or N can be applied to the film constituting the T-L composition layers 5.

[Example 16]

A composite magnetic thin film (Example 16) of the present invention was formed in the same manner as in Example 1 except that the Fe-C layers in Example 1 were replaced with FeCo-C layers. The FeCo-C layers were formed by use of a composite target in which C (carbon) pellets were arranged on a $Fe_{70}Co_{30}$ target.

[Example 17]

A composite magnetic thin film (Example 17) of the present invention was formed in the same manner as in Example 1 except that the Fe-C layers in Example 1 were replaced with FeCo-B layers. The FeCo-B layers were formed by use of a $Fe_{65}Co_{30}B_5$ alloy target.

[Example 18]

A composite magnetic thin film (Example 18) of the present invention was formed in the same manner as in Example 3 except that the Fe-C layers in Example 3 were replaced with FeCo-C layers. The FeCo-C layers were formed by use of a composite target in which C (carbon) pellets were arranged on a $Fe_{70}Co_{30}$ target.

[Example 19]

A composite magnetic thin film (Example 19) of the present invention was formed in the same manner as in Example 3 except that the Fe-C layers in Example 3 were replaced with FeCo-B layers. The FeCo-B layers were formed by use of a $Fe_{65}Co_{30}B_5$ alloy target.

[Example 20]

A composite magnetic thin film (Example 20) of the present invention was formed in the same manner as in Example 5 except that the Fe-C layers in Example 5 were replaced with FeCo-C layers. The FeCo-C layers were formed by use of a composite target in which C (carbon) pellets were arranged on a $Fe_{70}Co_{30}$ target.

[Example 21]

A composite magnetic thin film (Example 21) of the present invention was formed in the same manner as in Example 5 except that the Fe-C layers in Example 5 were replaced with FeCo-B layers. The FeCo-B layers were formed by use of a $Fe_{65}Co_{30}B_5$ alloy target.

[Example 22]

A composite magnetic thin film (Example 22) of the present invention was formed in the same manner as in Example 7 except that the Fe-C layers in Example 7 were replaced with FeCo-C layers. The FeCo-C layers were formed by use of a composite target in which C (carbon) pellets were arranged on a $Fe_{70}Co_{30}$ target.

[Example 23]

A composite magnetic thin film (Example 23) of the present invention was formed in the same manner as in Example 7 except that the Fe-C layers in Example 7 were replaced with FeCo-B layers. The FeCo-B layers were formed by use of a $Fe_{65}Co_{30}B_5$ alloy target.

[Example 24]

A composite magnetic thin film (Example 24) of the present invention was formed in the same manner as in Example 1 except that the Fe-C layers in Example 1 were replaced with FeCo-B-N layers. The FeCo-B-N layers were formed by use of a $Fe_{65}Co_{30}B_5$ alloy target and also by introducing N gas into the interior of the chamber in the sputtering apparatus while sputtering was being carried out.

[Example 25]

A composite magnetic thin film (Example 25) of the present invention was formed in the same manner as in Example 1 except that the Fe-C layers in Example 1 were replaced with FeCo-B-C layers. The FeCo-B-C layers were formed by use of a composite target in which C (carbon) pellets were arranged on a $Fe_{65}CO_{30}B_5$ alloy target.

[Example 26]

A composite magnetic thin film (Example 26) of the present invention was formed in the same manner as in Example 1 except that the Fe-C layers in Example 1 were replaced with FeCo-C-N layers. The FeCo-C-N layers were formed by use of a composite target in which C (carbon) pellets were arranged on a $Fe_{70}Co_{30}$ target and also by introducing N gas into the interior of the chamber in the sputtering apparatus while sputtering was being carried out.

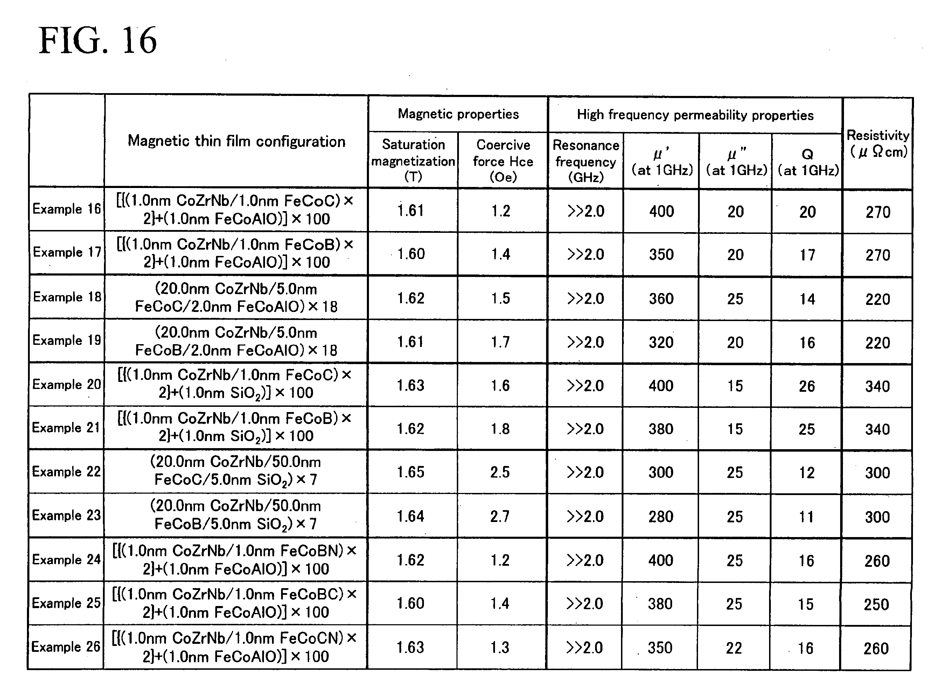

The magnetic properties, the high frequency permeability properties and the resistivities of the composite magnetic thin films obtained in Examples 16 to 26 were measured. The results obtained are collectively shown in Figure 16. The measurement conditions for the magnetic properties, the high frequency permeability properties and the resistivities were the same as described above.

As can be seen from Examples 16 to 26 in Figure 16, it is also effective to adopt FeCo for the T portion in the T-L composition layers 5 . It attracts the attention that Examples 16 to 26 all exhibited a saturation magnetization of 16 kG (1.6T) or more. Consequently, it has been found particularly effective in improving the saturation magnetization to adopt FeCo for the T portion in the T-L composition layers 5.

Industrial Applicability

According to the present invention, there is provided a magnetic thin film for high frequency which has a high permeability, a high saturation magnetization and also a high resistivity in a high frequency range, in particular, the GHz range.

**Claims**

1. A magnetic thin film for high frequency, **characterized by** comprising:

   a first layer comprising a T-L composition (wherein T is Fe or FeCo, and L is at least one element selected from the group consisting of C, B and N);
   a second layer comprising a Co based amorphous alloy and disposed on either of the surfaces of said first layer; and
   a third layer disposed on either of said first layer side or said second layer side, and having an electric resistance higher than said first layer and said second layer;

   wherein a plurality of said first layers, a plurality of said second layers and a plurality of said third layers are laminated to form a multilayer film structure.

2. The magnetic thin film for high frequency according to claim 1, **characterized in that** every time laminating of said first layer and said second layer is repeated a predetermined number of times, said third layer is disposed.

3. The magnetic thin film for high frequency according to claim 2, **characterized in that** said predetermined number of times is 1 to 5.

4. The magnetic thin film for high frequency according to claim 1, **characterized in that** T constituting said T-L composition is FeCo.

5. The magnetic thin film for high frequency according to claim 4, **characterized in that** the concentration of Co in said T-L composition is 10 to 50 at%.

6. The magnetic thin film for high frequency according to claim 1, **characterized in that** L constituting said T-L composition is C and/or B.

7. The magnetic thin film for high frequency according to claim 1, **characterized in that**:

   said Co based amorphous alloy comprises Co as a main component and an element M (wherein M is at least one element selected from the group consisting of B, C, Si, Ti, V, Cr, Mn, Fe, Ni, Y, Zr, Nb, Mo, Hf, Ta and W); and the concentration of said element M in said Co based amorphous alloy is 10 to 30 at%.

8. The magnetic thin film for high frequency according to claim 1, **characterized in that** said third layers are each at least one of a granular structure film, an oxide film, a nitride film and a fluoride film.

9. The magnetic thin film for high frequency according to claim 1, **characterized in that** the saturation magnetization thereof is 14 kG (1.4 T) or more and the resistivity thereof is 200 $\mu\Omega$ cm or more under the condition that said first layers, said second layers and said third layers are laminated.

10. The magnetic thin film for high frequency according to claim 1, **characterized in that** the real part ($\mu'$) of the complex permeability thereof at 1 GHz is 300 or more, and the quality factor Q (Q = $\mu'/\mu''$) thereof is 10 or more.

11. The magnetic thin film for high frequency according to claim 1, **characterized in that** when T1 denotes the thickness of each of said first layers and T2 denotes the thickness of each of said second layers, T1 falls within the range of 0.5 to 3.0 nm and T1/T2 falls within the range of 0.8 to 3.0.

12. The magnetic thin film for high frequency according to claim 1, **characterized in that** when T1 denotes the thickness of each of said first layers and T2 denotes the thickness of each of said second layers, T1 falls within the range of 3 to 70 nm and T1/T2 falls within the range of 0.15 to 3.50.

13. A composite magnetic thin film, comprising:

   a first layer which is mainly composed of Fe or FeCo, has by itself a saturation magnetization of 16 kG (1.6 T) or more, and is constituted as a columnar structure with an aspect ratio of 1.4 or less or as an amorphous structure; and a second layer which is mainly composed of Co, and has the properties by itself such that a permeability of 1000 or more (measurement frequency: 10 MHz), a saturation magnetization of 10 kG (1.0 T) or more, and a resistivity of 100 $\mu\Omega$ cm or more; the composite magnetic thin film being a laminate in which said first layers and said second layers are laminated;

**characterized in that**
   third layers each having an electric resistance higher than said second layers are disposed on the surface and/or in the interior of said laminate.

14. The composite magnetic thin film according to claim 13, **characterized in that** said third layers are each a magnetic substance.

15. The composite magnetic thin film according to claim 13, **characterized in that** the total thickness of said composite magnetic thin film is 200 to 3000 nm.

16. The composite magnetic thin film according to claim 13, **characterized in that** the proportion of said third layers in relation to said composite magnetic thin film is 40 vol% or less.

17. The composite magnetic thin film according to claim 16, **characterized in that** the proportion in relation to said composite magnetic thin film is 3 to 20 vol%.

18. The composite magnetic thin film according to claim 13, **characterized in that** said first layers are each composed of an amorphous structure.

19. A magnetic device comprising a magnetic thin film for high frequency, **characterized by** comprising:

   a first layer comprising a T-L composition (wherein T is Fe or FeCo, and L is at least one element selected from the group consisting of C, B and N); a second layer comprising a Co based amorphous alloy and disposed on either of the surfaces of said first layer; and a third layer disposed on either of said first layer side or said second layer side, and having an electric resistance higher than said first layer and said second layer;

   wherein a plurality of said first layers, a plurality of said second layers and a plurality of said third layers are laminated to form a multilayer film structure.

**20.** The magnetic device according to claim 19, **characterized in that** said third layers are each formed of a granular structure film.

**21.** The magnetic device according to claim 19, **characterized in that** the concentration of said element L contained in said T-L composition is 2 to 20 at%.

**22.** The magnetic device according to claim 19, **characterized in that** said magnetic device is an inductor or a transformer.

FIG. 1

# FIG. 2

# FIG. 3

101

100

# FIG. 4

112
111
112
111
112
111

110

# FIG. 5

## FIG. 6

# FIG. 7

# FIG. 8

FIG. 9

# FIG. 10

FIG. 11

# FIG. 12

| | T-L composition layer 5 | | Co based amorphous alloy layer 3 | | High resistance layer 7 | | Magnetic thin film configuration |
|---|---|---|---|---|---|---|---|
| | Film composition | Thickness T1 (nm) | Film composition | Thickness T2 (nm) | Film composition | Thickness T3 (nm) | |
| Example 1 | FeC | 1.0 | CoZrNb | 1.0 | FeCoAlO | 1.0 | [[(1.0nm CoZrNb/1.0nm FeC) × 2]+(1.0nm FeCoAlO)] × 100 |
| Example 2 | FeC | 1.5 | CoZrNb | 1.5 | FeCoAlO | 1.0 | [[(1.5nm CoZrNb/1.5nm FeC) × 3]+(1.0nm FeCoAlO)] × 50 |
| Example 3 | FeC | 5.0 | CoZrNb | 20.0 | FeCoAlO | 2.0 | (20.0nm CoZrNb/5.0nm FeC/2.0nm FeCoAlO) × 18 |
| Example 4 | FeC | 50.0 | CoZrNb | 20.0 | FeCoAlO | 5.0 | (20.0nm CoZrNb/50.0nm FeC/5.0nm FeCoAlO) × 7 |
| Example 5 | FeC | 1.0 | CoZrNb | 1.0 | $SiO_2$ | 1.0 | [[(1.0nm CoZrNb/1.0nm FeC) × 2]+(1.0nm $SiO_2$)] × 100 |
| Example 6 | FeC | 1.0 | CoZrNb | 1.0 | $SiO_2$ | 1.0 | (1.0nm CoZrNb/1.0nm FeC/1.0nm $SiO_2$) × 100 |
| Example 7 | FeC | 50.0 | CoZrNb | 20.0 | $SiO_2$ | 5.0 | (20.0nm CoZrNb/50.0nm FeC/5.0nm $SiO_2$) × 7 |
| Example 8 | FeC | 1.0 | CoZrNb | 1.0 | Spontaneous oxide film | 1.0 | [[(1.0nm CoZrNb/1.0nm FeC) × 2]+ (1.0nm Spontaneous oxide film) × 100 |
| Comparative Example 1 | Fe | 1.0 | CoZrNb | 1.0 | — | | (1.0nm CoZrNb/1.0nm Fe) × 250 |

EP 1 585 149 A1

# FIG. 13

| | T1／T2 | High resistance layer proportion (vol%) | Magnetic properties | | High frequency permeability properties | | | | Resistivity ($\mu$ Ω cm) |
| --- | --- | --- | --- | --- | --- | --- | --- | --- | --- |
| | | | Saturation magnetization (T) | Coercive force Hce (Oe) | Resonance frequency (GHz) | $\mu'$ (at 1GHz) | $\mu''$ (at 1GHz) | Q (at 1GHz) | |
| Example 1 | 1.00 | 20.00 | 1.45 | 0.8 | >>2.0 | 450 | 15 | 30 | 280 |
| Example 2 | 1.00 | 10.00 | 1.50 | 1.0 | >>2.0 | 500 | 20 | 25 | 240 |
| Example 3 | 0.25 | 7.41 | 1.45 | 1.3 | >>2.0 | 490 | 25 | 20 | 230 |
| Example 4 | 2.50 | 6.67 | 1.55 | 1.5 | >>2.0 | 420 | 20 | 21 | 210 |
| Example 5 | 1.00 | 20.00 | 1.43 | 0.9 | >>2.0 | 450 | 12 | 37 | 350 |
| Example 6 | 1.00 | 33.30 | 1.40 | 1.0 | >>2.0 | 400 | 10 | 40 | 500 |
| Example 7 | 2.50 | 6.67 | 1.45 | 1.8 | >>2.0 | 405 | 20 | 20 | 300 |
| Example 8 | 1.00 | 20.00 | 1.45 | 0.9 | >>2.0 | 450 | 12 | 37 | 350 |
| Comparative Example 1 | — | — | 2.07 | 4.2 | — | 150 | — | — | 70 |

EP 1 585 149 A1

FIG. 14

# FIG. 15

| | Magnetic thin film configuration | Magnetic properties | | High frequency permeability properties | | | | Resistivity ($\mu \Omega$cm) |
|---|---|---|---|---|---|---|---|---|
| | | Saturation magnetization (T) | Coercive force Hce (Oe) | Resonance frequency (GHz) | $\mu'$ (at 1GHz) | $\mu''$ (at 1GHz) | Q (at 1GHz) | |
| Example 9 | [[(1.0nm CoZrNb/1.0 nmFeB) × 2]+(1.0nm FeCoAlO)] × 100 | 1.46 | 0.9 | >>2.0 | 420 | 20 | 21 | 270 |
| Example 10 | (20.0nm CoZrNb/5.0nm FeB/2.0nm FeCoAlO) × 18 | 1.52 | 1.1 | >>2.0 | 450 | 15 | 30 | 220 |
| Example 11 | [[(1.0nm CoZrNb/1.0nm FeB) × 2]+(1.0nm SiO$_2$)] × 100 | 1.43 | 1.0 | >>2.0 | 450 | 14 | 30 | 350 |
| Example 12 | (20.0nm CoZrNb/50.0nm FeB/5.0nm SiO$_2$) × 7 | 1.45 | 1.8 | >>2.0 | 380 | 20 | 19 | 340 |
| Example 13 | [[(1.0nm CoZrNb/1.0nm FeBN) × 2]+(1.0nm FeCoAlO)] × 100 | 1.51 | 1.3 | >>2.0 | 320 | 15 | 21 | 280 |
| Example 14 | [[(1.0nm CoZrNb/1.0nm FeBC) × 2]+(1.0nm FeCoAlO)] × 100 | 1.46 | 0.8 | >>2.0 | 440 | 20 | 22 | 280 |
| Example 15 | [[(1.0nm CoZrNb/1.0nm FeCN) × 2]+(1.0nm FeCoAlO)] × 100 | 1.50 | 1.4 | >>2.0 | 350 | 20 | 17 | 270 |

# FIG. 16

| | Magnetic thin film configuration | Magnetic properties | | High frequency permeability properties | | | | Resistivity ($\mu\,\Omega$cm) |
|---|---|---|---|---|---|---|---|---|
| | | Saturation magnetization (T) | Coercive force Hce (Oe) | Resonance frequency (GHz) | $\mu'$ (at 1GHz) | $\mu''$ (at 1GHz) | Q (at 1GHz) | |
| Example 16 | [[(1.0nm CoZrNb/1.0nm FeCoC)×2}+(1.0nm FeCoAlO)] × 100 | 1.61 | 1.2 | >>2.0 | 400 | 20 | 20 | 270 |
| Example 17 | [[(1.0nm CoZrNb/1.0nm FeCoB)×2}+(1.0nm FeCoAlO)] × 100 | 1.60 | 1.4 | >>2.0 | 350 | 20 | 17 | 270 |
| Example 18 | (20.0nm CoZrNb/5.0nm FeCoC/2.0nm FeCoAlO)× 18 | 1.62 | 1.5 | >>2.0 | 360 | 25 | 14 | 220 |
| Example 19 | (20.0nm CoZrNb/5.0nm FeCoB/2.0nm FeCoAlO)× 18 | 1.61 | 1.7 | >>2.0 | 320 | 20 | 16 | 220 |
| Example 20 | [[(1.0nm CoZrNb/1.0nm FeCoC)×2}+(1.0nm SiO$_2$)] × 100 | 1.63 | 1.6 | >>2.0 | 400 | 15 | 26 | 340 |
| Example 21 | [[(1.0nm CoZrNb/1.0nm FeCoB)×2}+(1.0nm SiO$_2$)] × 100 | 1.62 | 1.8 | >>2.0 | 380 | 15 | 25 | 340 |
| Example 22 | (20.0nm CoZrNb/50.0nm FeCoC/5.0nm SiO$_2$) × 7 | 1.65 | 2.5 | >>2.0 | 300 | 25 | 12 | 300 |
| Example 23 | (20.0nm CoZrNb/50.0nm FeCoB/5.0nm SiO$_2$) × 7 | 1.64 | 2.7 | >>2.0 | 280 | 25 | 11 | 300 |
| Example 24 | [[(1.0nm CoZrNb/1.0nm FeCoBN)×2}+(1.0nm FeCoAlO)] × 100 | 1.62 | 1.2 | >>2.0 | 400 | 25 | 16 | 260 |
| Example 25 | [[(1.0nm CoZrNb/1.0nm FeCoBC)×2}+(1.0nm FeCoAlO)] × 100 | 1.60 | 1.4 | >>2.0 | 380 | 25 | 15 | 250 |
| Example 26 | [[(1.0nm CoZrNb/1.0nm FeCoCN)×2}+(1.0nm FeCoAlO)] × 100 | 1.63 | 1.3 | >>2.0 | 350 | 22 | 16 | 260 |

# EP 1 585 149 A1

<table>
<tr><td align="center"><strong>INTERNATIONAL SEARCH REPORT</strong></td><td>International application No.<br>PCT/JP03/16458</td></tr>
</table>

**A. CLASSIFICATION OF SUBJECT MATTER**
Int.Cl$^7$ H01F10/16, 10/13, 17/04, 17/00

According to International Patent Classification (IPC) or to both national classification and IPC

**B. FIELDS SEARCHED**

Minimum documentation searched (classification system followed by classification symbols)
Int.Cl$^7$ H01F10/16, 10/13, 17/04, 17/00

Documentation searched other than minimum documentation to the extent that such documents are included in the fields searched
| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 6-69032 A (Mitsubishi Electric Corp.), 11 March, 1994 (11.03.94), Full text; all drawings (Family: none) | 1-22 |
| Y | JP 5-55035 A (Alps Electric Co., Ltd.), 05 March, 1993 (05.03.93), Full text; all drawings (Family: none) | 1-22 |
| Y | JP 60-128605 A (Hitachi, Ltd.), 09 July, 1985 (09.07.85), Full text; all drawings & DE 3480571 D & EP 147126 A2 & US 4748089 A1 | 1-22 |

☒ Further documents are listed in the continuation of Box C. ☐ See patent family annex.

| | | |
|---|---|---|
| * | Special categories of cited documents: | |
| "A" | document defining the general state of the art which is not considered to be of particular relevance | |
| "E" | earlier document but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 19 February, 2004 (19.02.04) | 02 March, 2004 (02.03.04) |

| Name and mailing address of the ISA/ | Authorized officer |
|---|---|
| Japanese Patent Office | |
| Facsimile No. | Telephone No. |

Form PCT/ISA/210 (second sheet) (July 1998)

**INTERNATIONAL SEARCH REPORT**

International application No.

PCT/JP03/16458

C (Continuation). DOCUMENTS CONSIDERED TO BE RELEVANT

| Category* | Citation of document, with indication, where appropriate, of the relevant passages | Relevant to claim No. |
|---|---|---|
| Y | JP 9-63844 A (Toshiba Corp.), 07 March, 1997 (07.03.97), Full text; all drawings (Family: none) | 1-22 |
| Y | JP 6-132128 A (Mitsubishi Rayon Co., Ltd.), 13 May, 1994 (13.05.94), Par. Nos. [0003], [0010], [0011] (Family: none) | 1-22 |
| Y | JP 2000-54083 A (Alps Electric Co., Ltd.), 22 February, 2000 (22.02.00), Claims; Par. Nos. [0026], [0027] (Family: none) | 1-22 |
| Y | JP 59-130408 A (Hitachi, Ltd.), 27 July, 1984 (27.07.84), Page 2, lower right column, line 6 to page 3, upper left column, line 4 & DE 3485393 A & EP 114076 A2 & US 4610935 A1 | 13 |
| Y | JP 10-189322 A (TDK Corp.), 21 July, 1998 (21.07.98), Par. Nos. [0017], [0018] | 8,14,20 |
| Y | JP 10-241938 A (The Research Institute for Electric and Magnetic Materials), 11 September, 1998 (11.09.98), Par. No. [0016] | 8,14,20 |
| A | JP 2000-252121 A (Alps Electric Co., Ltd.), 14 September, 2000 (14.09.00), Full text; all drawings (Family: none) | 1-22 |

Form PCT/ISA/210 (continuation of second sheet) (July 1998)